(19) Europäisches Patentamt
European Patent Office
Office européen des brevets

(11) **EP 4 220 723 B1**

(12) **FASCICULE DE BREVET EUROPÉEN**

(45) Date de publication et mention de la délivrance du brevet:
**21.02.2024 Bulletin 2024/08**

(21) Numéro de dépôt: **23153852.1**

(22) Date de dépôt: **30.01.2023**

(51) Classification Internationale des Brevets (IPC):
**H01L 27/146** [(2006.01)]

(52) Classification Coopérative des Brevets (CPC):
**H01L 27/14621; H01L 27/14685**

(54) **PROCÉDÉ DE FABRICATION D'UN FILTRE MULTISPECTRAL POUR UNE RADIATION ÉLECTROMAGNÉTIQUE**

VERFAHREN ZUR HERSTELLUNG EINES MULTISPEKTRALEN FILTERS FÜR ELEKTROMAGNETISCHE STRAHLUNG

METHOD FOR PRODUCING A MULTISPECTRAL FILTER FOR ELECTROMAGNETIC RADIATION

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **01.02.2022 FR 2200868**

(43) Date de publication de la demande:
**02.08.2023 Bulletin 2023/31**

(73) Titulaire: **COMMISSARIAT À L'ÉNERGIE ATOMIQUE ET AUX ÉNERGIES ALTERNATIVES
75015 Paris (FR)**

(72) Inventeurs:
- **LANDIS, Stefan
  38054 GRENOBLE CEDEX 09 (FR)**
- **BERARD-BERGERY, Sébastien
  38054 GRENOBLE CEDEX 09 (FR)**

(74) Mandataire: **Cabinet Camus Lebkiri
25 rue de Maubeuge
75009 Paris (FR)**

(56) Documents cités:
**US-A1- 2014 085 727     US-A1- 2017 294 478
US-A1- 2021 255 543**

## Description

### DOMAINE TECHNIQUE DE L'INVENTION

Le domaine technique de l'invention est celui du filtrage spectral, notamment pour des applications d'imagerie et la réalisation de filtres colorés pour les capteurs d'images de type CMOS, les dispositifs d'affichage à cristaux liquides ou des diodes électroluminescentes. L'invention peut également être mise en en oeuvre dans des dispositifs d'émission de la lumière.

La présente invention concerne un procédé de fabrication d'un filtre multispectral pour une radiation électromagnétique.

### ARRIERE-PLAN TECHNOLOGIQUE DE L'INVENTION

Un filtre spectral ou encore un filtre de couleur permet de filtrer la lumière par longueur d'onde, de façon à fournir une information sur l'intensité de la lumière dans certaines longueurs d'onde. Plusieurs filtres de couleur peuvent être associés de façon à former, par exemple, des filtres rouge-vert-bleu (RGB dans la terminologie anglaise) qui renseignent sur l'intensité de ces trois couleurs.

On connait notamment des filtres de couleur de type métal/diélectrique réalisés à partir d'une cavité de Fabry-Pérot. Ces filtres comprennent une ou plusieurs cavités diélectriques (ou éventuellement semiconductrices) formées entre deux films minces de métal ayant une fonction de miroir métallique de façon à former une cavité de Fabry-Pérot. Un exemple de ce type de filtre est décrit dans le document US6031653. Généralement, les empilements métal/diélectrique sont différents suivant la position sur le composant optoélectronique (un capteur d'image par exemple). La transmission du filtre est réglée en ajustant l'épaisseur de la cavité. Ainsi, en fonctionnement, une partie de la lumière incidente correspondant à la longueur d'onde du filtre est transmise à travers celui-ci sous la forme d'un faisceau coloré, tandis que le reste de la lumière incidente est réfléchie. De façon générale, l'épaisseur de la couche diélectrique fixe la longueur d'onde centrale transmise, tandis que l'épaisseur des couches métalliques permet de régler la largeur spectrale de transmission. Par ailleurs, l'utilisation de plusieurs cavités de Fabry-Pérot permet de modifier le profil spectral de la transmission du filtre. Un filtre de ce type est réalisé en utilisant des techniques classiques de fabrication de semi-conducteurs. Ainsi, pour obtenir un filtre rouge-vert-bleu, il convient de former au moins une cavité diélectrique dont l'épaisseur doit présenter trois valeurs différentes. Cela entraîne des contraintes technologiques importantes, notamment au moins une étape de masquage puis de gravure pour chaque cavité diélectrique réalisée.

Il a également été montré que l'on pouvait utiliser un réseau de filtres multispectraux pour l'imagerie directement réalisé sur un réseau de capteurs optiques selon une technique de fabrication compatible CMOS (approche bottom-up selon la terminologie anglaise). Ces techniques sont notamment décrites dans le document EP2522968.

Plus récemment, il a également été décrit (cf. document WO2019/239139) la faisabilité de dispositifs optiquement fonctionnels suite à la création de cavités de Fabry-Pérot au-dessus d'un dispositif capteur d'image CMOS.

Toutes les solutions évoquées ci-dessus nécessitent de nombreuses étapes successives de lithographie et de gravure pour réaliser les différentes épaisseurs de couches diélectriques permettant d'assurer le filtrage des différentes couleurs.

En outre, lors de la gravure de structures, différents phénomènes peuvent conduire à des déformations de profils, à des non-uniformités de gravure générées par des effets d'« ARDE » (pour « Aspect Ratio Dependent Etching » selon la terminologie anglaise) ou à des qualités de surface dégradées. Or, il est important de conserver le facteur de forme AR (pour « Aspect Ratio ») pour des dispositifs tels que des filtres multispectraux.

### RESUME DE L'INVENTION

L'invention offre une solution aux problèmes évoqués précédemment, en proposant un procédé de fabrication d'un filtre multispectral pour une radiation électromagnétique permettant de s'affranchir des étapes successives de lithographie et gravure de matériau diélectrique pour la réalisation des différentes épaisseurs de diélectriques et d'obtenir des profils et des qualités de surfaces améliorés.

Pour ce faire, l'invention a pour objet un procédé de fabrication d'un filtre multispectral pour une radiation électromagnétique, ledit filtre comportant au moins deux filtres de couleur, chaque filtre comportant une première couche réfléchissante, une deuxième couche réfléchissante, une couche en matériau diélectrique de cavité de Fabry-Pérot entre la première couche réfléchissante et la deuxième couche réfléchissante, l'épaisseur de la couche diélectrique des deux filtres de couleurs étant différente et chacun des deux filtres étant en regard d'un transducteur photoélectrique, ledit procédé comportant les étapes suivantes :

- Dépôt sur un substrat, dit substrat poignée, d'une couche de résine ;

- Structuration en trois dimensions de la couche de résine par lithographie de sorte à obtenir au moins deux motifs de résines de hauteurs différentes, au moins un des motifs présentant une hauteur maximale de référence, la hauteur étant mesurée perpendiculairement au plan du substrat ;

- Dépôt d'une couche réalisée dans le matériau diélectrique destiné à former les motifs diélectriques des cavités de Fabry-Pérot, ladite couche de matériau diélectrique recouvrant la totalité des motifs de résine en présentant une surface supérieure dont chaque point est situé à une hauteur relativement au substrat poignée supérieure à la hauteur maximale de référence ;

- Planarisation par retrait du matériau diélectrique avec arrêt sélectif au sommet du motif de résine le plus haut ;

- Report de la face planarisée du substrat poignée sur la face supérieure d'un substrat, dit substrat porteur, comportant au moins deux transducteurs photoélectriques, chacun desdits motifs étant en regard d'un transducteur photoélectrique, une couche réfléchissante destinée à former la première couche réfléchissante des deux filtres de couleurs étant positionnée à l'interface de report entre le substrat poignée et le substrat porteur ;

- Retrait du substrat poignée ;

- Retrait de la résine de sorte à libérer en surface au moins deux motifs diélectriques de cavités de Fabry-Pérot d'épaisseur différente ;

- Dépôt d'une couche réfléchissante sur les au moins deux motifs diélectriques de cavité de Fabry-Pérot, formant la deuxième couche réfléchissante des deux filtres de couleurs.

Grâce à l'invention, les cavités Fabry Pérot sont réalisées sur un substrat de support temporaire, dit substrat poignée, par remplissage d'une structure 3D en résine préalablement réalisée par une lithographie 3D obtenue en une étape permettant de s'affranchir des nombreuses étapes de successives de lithographie et gravure de matériau diélectrique formant le coeur des cavités. Le substrat support est ensuite reporté sur un substrat supportant les composants optoélectroniques d'intérêt. Un autre avantage de l'invention consiste à ne pas transférer verticalement les motifs dans le matériau diélectrique formant les coeurs des cavités de Fabry-Pérot via une approche classique par gravure et ainsi permettre de conserver une bonne qualité de surface et le facteur de forme souhaité.

Outre les caractéristiques qui viennent d'être évoquées dans le paragraphe précédent, le procédé l'invention peut présenter une ou plusieurs caractéristiques complémentaires parmi les suivantes, considérées individuellement ou selon toutes les combinaisons techniquement possibles :

- l'étape de structuration est suivie, avant le dépôt de la couche réalisée dans le matériau diélectrique destiné à former les motifs diélectriques des cavités de Fabry-Pérot, d'une étape de dépôt conforme d'une couche d'encapsulation sur les motifs de résine.

- la lithographie utilisée pour l'étape de structuration est une lithographie en niveaux de gris dite Grayscale.

- la couche réfléchissante destinée à former la première couche réfléchissante des filtres de couleurs est préalablement déposée sur le substrat porteur au-dessus des transducteurs photoélectriques.

- une couche de matériau diélectrique est déposée sur ladite couche réfléchissante du substrat porteur de façon à assurer un contact diélectrique/diélectrique lors du report de la face planarisée du substrat poignée sur la face supérieure du substrat porteur.

- Le procédé selon l'invention comporte une étape de réalisation de marques d'alignement, lesdites marques d'alignement étant réalisées dans le substrat poignée ou dans la couche de résine, des marques d'alignement étant également présentes dans le substrat porteur de façon à assurer la mise en regard de chacun des motifs de résine avec un transducteur photoélectrique.

- Le procédé selon l'invention comporte une étape de dépôt d'une couche d'arrêt préalable à l'étape de dépôt la couche de résine, le retrait du substrat poignée s'arrêtant sur ladite couche d'arrêt et étant suivi du retrait de la couche d'arrêt de sorte à libérer en surface la couche de résine structurée.

- Selon une première variante, le procédé selon l'invention comporte une étape de réalisation de murs d'air séparant les motifs diélectriques de cavités de Fabry-Pérot.

- Selon une seconde variante, le procédé selon l'invention comporte une étape de réalisation de murs de matériau présentant un indice de réfraction optique strictement inférieur à l'indice de réfraction du matériau diélectrique destiné à former les motifs diélectriques des cavités de Fabry-Pérot, lesdits murs séparant les motifs diélectriques des cavités de Fabry-Pérot.

- Le procédé selon l'invention comporte, en plus de la réalisation d'au moins deux filtres de couleurs, chaque filtre comportant une première couche réfléchissante, une deuxième couche réfléchissante, une couche en matériau diélectrique de cavité de Fabry-Pérot entre la première couche réfléchissante et la deuxième couche réfléchissante, la réalisation d'au moins un autre filtre de couleur comportant une première couche réfléchissante, une deuxième couche réfléchissante, une couche en matériau diélectrique de cavité de Fabry-Pérot, dite d'un second type, entre la première couche réfléchissante et la deuxième couche réfléchissante, le matériau diélectrique de cet autre filtre de couleur étant différent du matériau diélectrique des deux filtres de couleur. Avantageusement, ladite étape de structuration en trois dimensions de la couche de résine par lithographie est réalisée de sorte à obtenir un emplacement libre dans lequel est déposée le matériau diélectrique destiné à former le motif de la cavité de Fabry-Pérot d'un second type.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

- La [Fig. 1] montre une représentation schématique d'un schéma synoptique du procédé selon un premier mode de réalisation de l'invention ;

- Les [Fig. 2], [Fig. 3], [Fig. 4], [Fig. 5], [Fig. 6], [Fig. 7], [Fig. 8], [Fig. 9], [Fig. 10], [Fig. 11], [Fig. 12] et [Fig. 13] illustrent les étapes du procédé de la figure 1 ;

- La [Fig. 14] montre une représentation schématique d'un schéma synoptique du procédé selon un second mode de réalisation de l'invention;

- Les [Fig. 15], [Fig. 16], [Fig. 17], [Fig. 18], [Fig. 19], [Fig. 20], [Fig. 21], [Fig. 22], [Fig. 23], [Fig. 24], [Fig. 25], [Fig. 26], [Fig. 27], [Fig. 28], [Fig. 29], [Fig. 30], [Fig. 31], [Fig. 32] et [Fig. 33] illustrent les étapes du procédé de la figure 14 ;

- La [Fig. 34] montre une représentation schématique d'un schéma synoptique du procédé selon un troisième mode de réalisation de l'invention;

- Les [Fig. 35], [Fig. 36], [Fig. 37], [Fig. 38] et [Fig. 39] illustrent les étapes du procédé de la figure 34 ;

- La [Fig. 40] montre une représentation schématique d'un schéma synoptique du procédé selon un quatrième mode de réalisation de l'invention ;

- Les [Fig. 41], [Fig. 42] et [Fig. 43] illustrent les étapes du procédé de la figure 40 ;

- La [Fig. 44] montre une représentation schématique d'un schéma synoptique du procédé selon un cinquième mode de réalisation de l'invention ;

- Les [Fig. 45], [Fig. 46], [Fig. 47], [Fig. 48] et [Fig. 49] illustrent les étapes du procédé de la figure 44.

**DESCRIPTION DETAILLEE**

Les figures sont présentées à titre indicatif et nullement limitatif de l'invention

Il convient de rappeler au préalable que, de façon générale et bien connue de l'homme du métier, un filtre de couleur de type métal/diélectrique réalisé à partir d'une cavité de Fabry-Pérot est obtenu en dimensionnant l'épaisseur de la couche diélectrique formée entre les deux couches métalliques. Si le filtrage de plusieurs couleurs est recherché sur un même composant, il est alors nécessaire d'être en mesure d'obtenir une épaisseur de diélectrique d'épaisseur variable sur ce même composant.

Ce dimensionnement est par exemple réalisé à l'aide d'un programme de calcul électromagnétique tel que le formalisme de transfert de matrices d'Abeles ou un calcul de diffraction pour les pixels dont la taille est proche de la longueur d'onde tel que le formalisme de la Méthode Modale par Expansion de Fourier ou l'analyse rigoureuse par ondes couplées (RCWA selon la terminologie anglaise).

Ces programmes de calcul permettent de déterminer les paramètres optimaux des empilements métal diélectrique pour chaque pixel. Le calcul prend notamment en compte les épaisseurs des couches de métal et de diélectrique ainsi que leurs indices, le spectre et la distribution angulaire de la lumière incidente. Par exemple, dans le cas des filtres de Fabry-Pérot, la longueur d'onde centrale du filtre est déterminée approximativement par la formule suivante :

$$\lambda_{res} = \frac{2hn.\cos\theta}{m - \frac{\phi_1 + \phi_2}{2\pi}}$$

où

- h est l'épaisseur de la cavité, c'est-à-dire approximativement l'épaisseur de la couche diélectrique
- m, nombre entier positif entre 1 et 10, est l'ordre de la cavité,
- n est l'indice effectif de la cavité, et
- φ1 et φ2 sont les déphasages à la réflexion sur les miroirs métalliques (déterminés par la nature des matériaux en jeu et la longueur d'onde considérée),
- θ est l'angle d'incidence de la lumière incidente sur le filtre (compté à partir de la perpendiculaire à la surface du filtre).

Une fois l'ordre de la cavité choisi, l'angle d'attaque connu, l'indice et les déphasages connus, il ne reste plus alors qu'à déterminer une épaisseur approximative h pour que la cavité soit centrée sur une longueur d'onde particulière. Une fois la fonction de filtrage calculée pour chaque filtre et chaque longueur d'onde, les épaisseurs h des diélectriques sont alors ajustées en fonction des performances recherchées (recherche d'un bon rapport signal sur bruit, d'un maximum de transmission, etc.).

Une autre méthode plus empirique consiste à calculer, pour plusieurs épaisseurs h, la réponse de l'empilement et à choisir h tel que le pic de résonance du filtre (Xres) soit positionné conformément au cahier des charges.

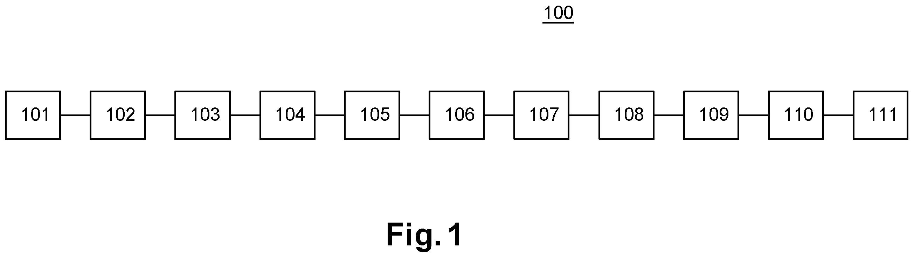

La [Fig. 1] montre une représentation schématique d'un schéma synoptique d'un procédé 100 selon un premier mode de réalisation de l'invention.

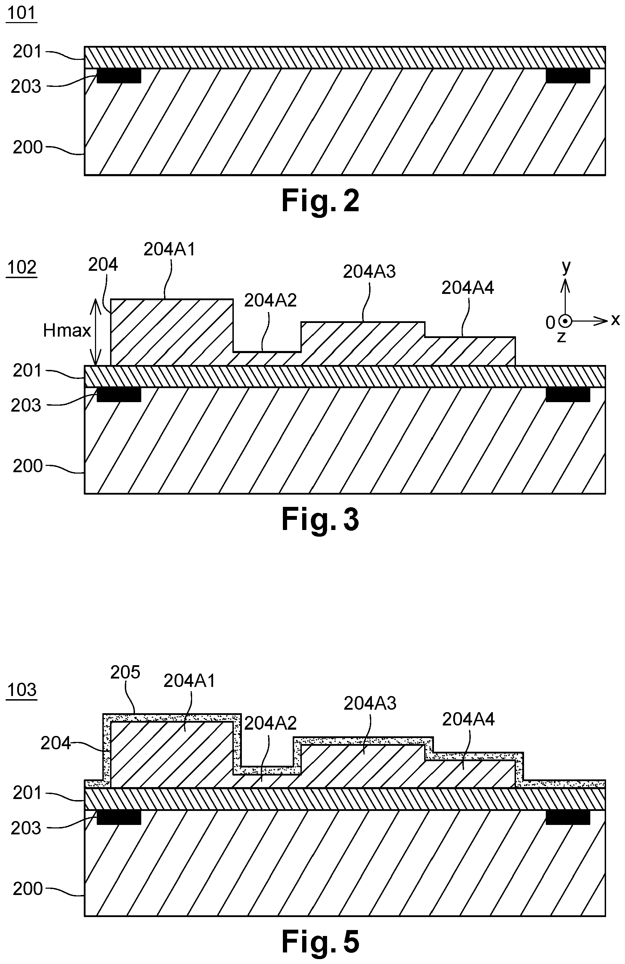

La première étape 101 du procédé 100 illustrée en [Fig. 2] consiste à déposer sur un substrat 200, dit substrat poignée, une couche dite d'arrêt 201 qui servira de couche d'arrêt lors des étapes de libération ultérieures. Le substrat 200 peut par exemple être un substrat en Si, un substrat Silicium sur Isolant SOI (pour « Silicon On Insulator » selon la terminologie anglaise) ou un substrat en verre ou en saphir. La couche d'arrêt 201 peut être par exemple une couche en matériau diélectrique tel que du SiN. De manière avantageuse, cette première étape 101 comporte également une sous-étape de réalisation de marques d'alignement 203, lesdites marques d'alignement étant réalisées dans le substrat poignée 200. Nous verrons par la suite que ces marques 203 d'alignement sont d'autant plus utiles pour des pixels de faible dimension ou dans le cas d'utilisation de murs d'isolation. Ces marques 203 sont réalisées par des techniques connues de l'homme du métier telles que des techniques de lithographie et gravure.

La seconde étape 102 illustrée en [Fig. 3] consiste à déposer une couche de résine puis à structurer en trois dimensions ladite couche de résine 204. La structuration 3D est réalisée par une étape de lithographie. Cette lithographie peut être préférentiellement une lithographie en niveaux de gris ou Grayscale selon la terminologie anglaise électronique ou optique (suivie d'une stabilisation de la résine Grayscale par procédé thermique ou ultraviolet). D'autres techniques de lithographie telles que la lithographie à deux photons ou par nano-impression peuvent également être utilisées pour la réalisation de la structure en résine 204. La structure 204 comporte une pluralité de motifs 204Ai en 3D (ici 4 motifs 204A1, 204A2, 204A3 et 204A4). Il est possible de fixer librement les dimensions de chaque motif dans les trois directions de l'espace Oxyz (où Oxy est le plan de la figure, l'axe Oy étant selon la direction perpendiculaire au plan du substrat 200 et l'axe Oz étant selon la direction perpendiculaire au plan de la figure).

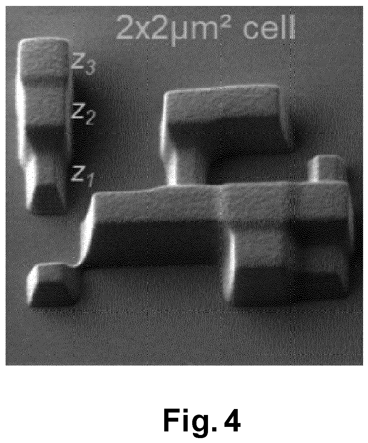

A titre illustratif, la [Fig. 4] montre une image de 3 motifs en 3D z1, z2 et z3 de dimensions différentes obtenus par structuration d'une couche de résine.

Selon l'invention, il convient d'avoir au moins deux motifs 204Ai de résine de hauteurs différentes (ici les 4 motifs ont chacun des hauteurs différentes). Parmi l'ensemble de ces motifs 204Ai, l'un d'eux, ici le motif 204A1, présente une hauteur maximale Hmax, dite de référence, la hauteur étant mesurée perpendiculairement au plan du substrat 200 suivant l'axe Ox. Nous reviendrons sur la détermination des hauteurs de chaque motif 204Ai dans la suite de la description.

Avantageusement, le procédé 100 selon l'invention comporte une troisième étape 103 illustrée en [Fig. 5] consistant à réaliser un dépôt conforme d'une couche d'encapsulation 205 sur les motifs de résine 204Ai. Le matériau de la couche d'encapsulation 205 peut être par exemple de l'Al2O3 ou du SiO2 et le dépôt sera préférentiellement réalisé par une technique de dépôt basse température tel qu'un dépôt par couches atomiques ALD (« Atomic Layer Déposition » selon la terminologie anglaise). Avantageusement, le matériau de la couche d'encapsulation 205 présente un indice optique proche de (voire identique à) l'indice optique du matériau diélectrique utilisé pour les motifs des cavités de Fabry-Pérot qui seront définis dans ce qui suit. On notera que le matériau de la couche d'encapsulation 205 peut également être un métal déposé de façon conforme.

Pour chaque motif de résine 204Ai, on notera Hres(i) la hauteur du motif, la hauteur étant mesurée perpendiculairement au plan du substrat. Ainsi, pour le motif 204A1, Hres(1) est ici égale à la hauteur de référence Hmax.

Si le procédé 100 selon l'invention comporte l'étape 103 d'encapsulation, Hres(i) inclut à la fois l'épaisseur de la résine 204 mais aussi l'épaisseur de la couche d'encapsulation 205 ; en l'absence de l'étape 103, Hres(i) est formée uniquement par l'épaisseur du motif 204Ai.

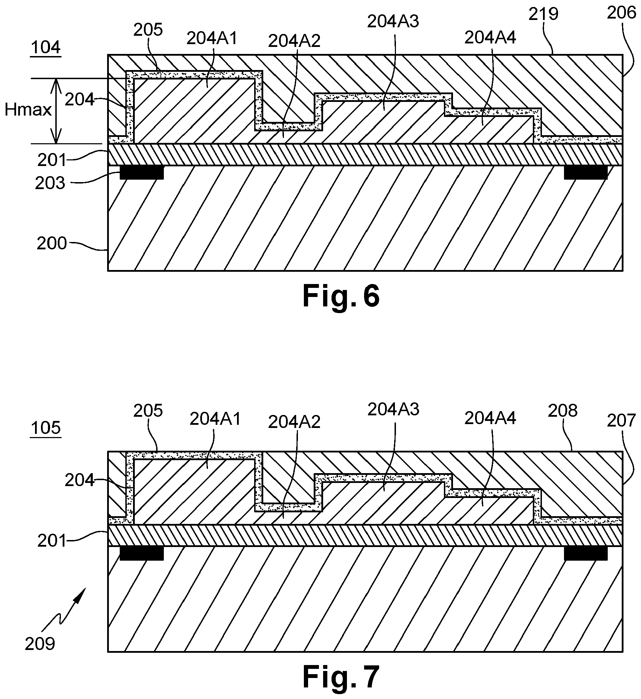

Le procédé 100 selon l'invention comporte ensuite une étape 104 illustrée en [Fig. 6] visant à déposer une couche 206 réalisée dans le matériau diélectrique destiné à former les motifs diélectriques des cavités de Fabry-Pérot. La couche 206 de matériau diélectrique recouvre la totalité des motifs de résine 204Ai. En d'autres termes, elle présente une surface supérieure 219 (non nécessairement plane) dont chaque point est situé à une hauteur, relativement au substrat poignée, supérieure à la hauteur maximale de référence Hmax. Ainsi, la couche 206 remplit entièrement les vides entre les motifs de résine 204Ai et vient se situer dans sa totalité au-dessus du motif de résine 204A1 le plus haut de la structure. Le matériau de la couche 206 est préférentiellement mais non limitativement un matériau transparent dans le domaine du visible tel qu'un matériau organique du type polymère ou inorganique (oxyde, nitrure de silicium, alumine, ...). Il convient de noter que l'invention ne se limite pas au domaine du visible et que d'autres matériaux transparents à d'autres longueurs d'onde, dans l'infrarouge par exemple (par exemple en utilisant du silicium), peuvent être utilisés. Nous verrons dans un autre mode de réalisation que l'invention peut également s'appliquer à plusieurs matériaux pour couvrir une gamme spectrale plus importante. On notera que cette étape pourrait être réalisée en l'absence de la couche d'encapsulation (i.e. directement sur les motifs 3D de résine 204Ai) : toutefois, l'avantage de la couche d'encapsulation est d'empêcher une éventuelle déformation des motifs de résine, cette dernière étant susceptible de se liquéfier à partir de certaines température (i.e. par exemple pendant le dépôt de la couche 206) : dès lors, la couche d'encapsulation permet de maintenir la structure 3D pendant le dépôt de la couche 206. Un autre avantage de la couche d'encapsulation est de faciliter le dépôt de la couche 206, notamment si les matériaux des couches 204 et 206 sont très différents (par exemple, organique d'un côté et inorganique de l'autre). Déposer la couche 206 directement sur les motifs 204Ai pourrait en effet poser des problèmes d'adhésion. Pour pallier cette difficulté, on peut choisir un matériau de couche d'encapsulation 205 adapté pour recevoir le matériau diélectrique de la couche 206.

Le procédé 100 comporte alors en [Fig. 7] une étape de planarisation de la couche 206 réalisée dans le matériau diélectrique destiné à former les motifs diélectriques des cavités de Fabry-Pérot de façon à former une couche 207 planarisée en surface par retrait du matériau diélectrique de la couche 206. L'étape de planarisation peut être réalisée par une étape de gravure de type etch-back éventuellement suivie d'une étape de polissage mécano-chimique CMP (Chemical Mechanical Polishing selon la terminologie anglaise). La planarisation s'effectue avec arrêt sur la couche d'encapsulation 205 située à son niveau le plus haut (i.e. au niveau de la hauteur de référence du motif 204A1). On notera qu'en l'absence de couche d'encapsulation 205, la planarisation s'arrêterait directement sur le motif 204A1. L'un des intérêts de la présence de la couche d'encapsulation est que cette dernière protège les motifs de résine 3D 204Ai qui peuvent être réalisés dans un matériau plus tendre sans être endommagés.

On note Hdiel(i) la hauteur du matériau diélectrique de la couche 206 au-dessus du motif 204Ai. Pour tous les motifs 204Ai correspondant à un futur pixel du filtre, la somme Hdiel(i)+Hres(i) doit être constante et égale. La hauteur Hdiel(i) correspond à l'épaisseur de la couche diélectrique de la ième cavité de Fabry-Pérot et peut être déterminée selon les méthodes mentionnées plus haut (en fonction du cahier des charges pour le filtrage recherché) : ainsi, par soustraction, entre la hauteur Hdiel(i)+Hres(i) constante donnée quelle que soit la valeur de i et la hauteur Hdiel(i), on obtient la hauteur Hres(i) de chaque motif de résine 3D à fabriquer à l'étape 102 (le cas échéant en prenant en compte l'épaisseur de la couche d'encapsulation 205).

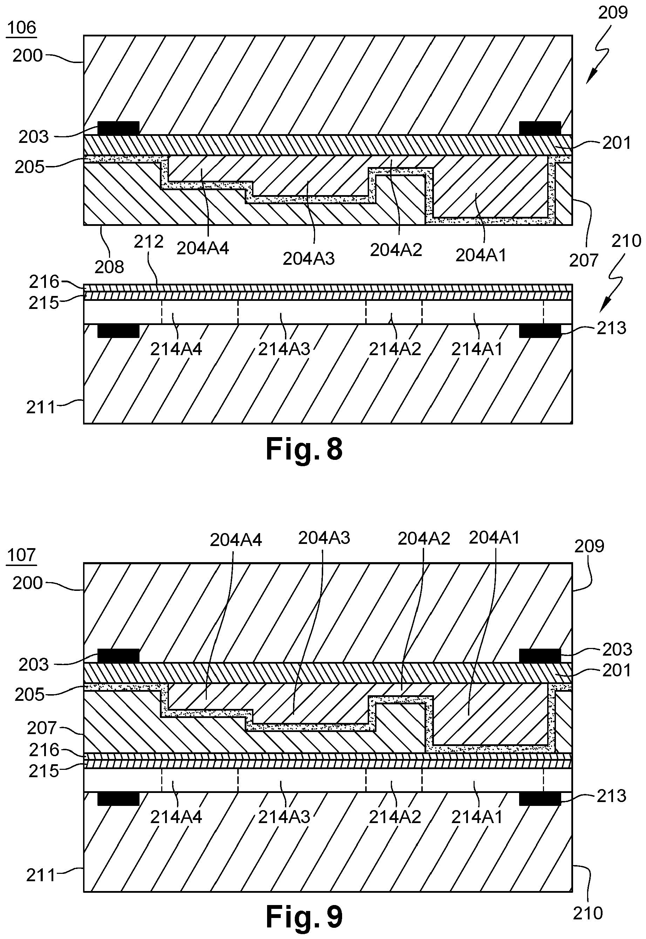

L'étape 106 du procédé 100 représentée en [Fig. 8] consiste à retourner le dispositif 209 obtenu à l'issue de l'étape 105 pour reporter la face planarisée du dispositif 209 formé par le substrat poignée sur la face supérieure 212 d'un substrat, dit substrat porteur 210.

Le substrat porteur 210 comporte un substrat 211 dans lequel sont réalisés des marques d'alignement 213. Ces marques d'alignement 213 vont être placées en regard des marques d'alignement 203 du dispositif 209. Sur le substrat 211 sont formés une pluralité de transducteurs (au moins deux) photoélectriques 214Ai, chacun délimité par des pointillés (ici 4 transducteurs photoélectriques 214A1, 214A2, 214A3 et 214A4 sont représentés). Les transducteurs photoélectriques peuvent fonctionner soit en tant que collecteur de lumière issue des filtres soit en tant qu'émetteur de lumière vers les filtres. S'il s'agit de collecteurs, les transducteurs peuvent être par exemple des photodiodes de type CMOS. S'il s'agit d'émetteurs, les transducteurs peuvent être par exemple des diodes LED, des diodes de type QLED ou des diodes LASER, les émetteurs présentant dans ce cas un spectre d'émission plus large que celui des cavités de Fabry-Pérot correspondantes. Le substrat porteur 210 comporte par ailleurs au-dessus des transducteurs 214Ai, une couche réfléchissante 215 destinée à former la première couche réfléchissante (ou couche miroir) des filtres de couleurs Fabry-Pérot. Dans le mode de réalisation de la figure 8 et de façon nullement limitative, on dispose au-dessus de la couche réfléchissante 215, une couche diélectrique 216 visant à favoriser le report de la surface planarisée 208 de la couche diélectrique 207. Dans l'hypothèse de la présence de cette couche diélectrique 216, il convient de prendre en compte l'épaisseur de cette couche dans la valeur de Hdiel(i) pour le dimensionnement des motifs de résine 3D 204Ai.

Lors du report de la face planarisée 208 du dispositif 209 formé par le substrat poignée sur la face supérieure 212 du substrat porteur 210, on utilise avantageusement les marques d'alignement (respectivement 203 et 213) de sorte que chacun des motifs de résine 3D 204Ai soit en regard d'un transducteur photoélectrique 214Ai. En d'autres termes, les motif 204A1, 204A2, 204A3 et 204A4 sont respectivement en regard des transducteurs 214A1, 214A2, 214A3 et 214A4. Comme évoqué plus haut, il est possible de s'affranchir de l'utilisation des marques d'alignement pour des tailles de motifs de dimension suffisamment grande. En revanche, un alignement fin entraînera préférentiellement la présence des marques d'alignement 203 et 213.

L'étape 107 du procédé 100 représentée en [Fig. 9] est le prolongement de l'étape 106 et vise à coller la surface planarisée 208 de la couche diélectrique 207 sur la surface 212 de la couche diélectrique 216.

Selon une alternative non représentée, on pourrait s'affranchir de la présence de la couche diélectrique 216 sur le substrat support 210 et prévoir une répartition de la couche réfléchissante en deux couches réfléchissantes, l'une qui serait présente sur le dispositif 209 formée par le substrat poignée et l'autre telle que la couche 215 illustrée en figure 8. Dans ce cas, le collage entre le dispositif poignée 209 et le substrat support 210 se fera via un collage entre les deux couches réfléchissantes (collage métal/métal au lieu d'un collage diélectrique/diélectrique). Selon cette variante comme dans le précédent mode de réalisation, la couche réfléchissante destinée à former la première couche réfléchissante des deux filtres de couleurs est positionnée à l'interface de report entre le substrat poignée et le substrat porteur.

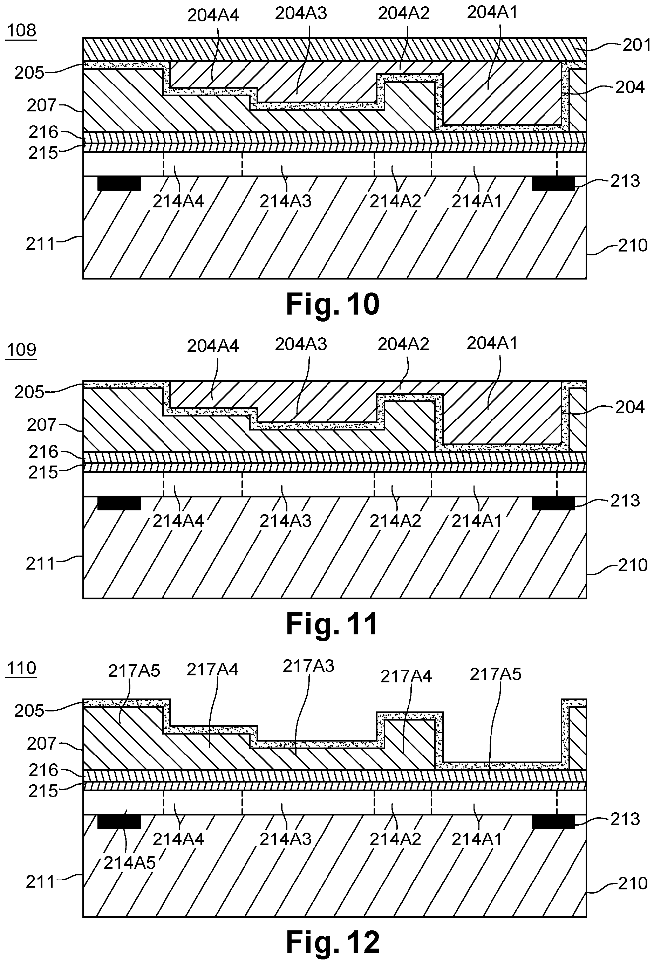

Conformément à la [Fig. 10], le procédé 100 selon l'invention comporte une étape 108 de retrait du substrat poignée 200 avec arrêt sur la couche d'arrêt 201 qui sert de couche de protection pour les motifs de résine 204Ai. Cette opération peut être par exemple faite par gravure, polissage de type CMP ou meulage de type grinding.

Le procédé 100 comporte ensuite :

- une étape 109 de retrait de la couche d'arrêt 201 illustrée en [Fig. 11], par exemple par un procédé de gravure sèche ou humide de sorte à libérer en surface la résine.

- Une étape 110 de retrait de la résine 204 (et donc de l'ensemble des motifs 204Ai) illustrée en [Fig. 12] avec arrêt sur la couche d'encapsulation 205, par exemple par une technique de gravure chimique de type stripping ; on voit ici un autre avantage de la couche d'encapsulation 205 qui facilite le retrait sélectif de la résine 204 par rapport au matériau diélectrique de la couche 206.

L'étape 110 permet de libérer en surface une pluralité (au moins deux) de motifs diélectriques 217Ai de cavités de Fabry-Pérot d'épaisseur différente : ici, cinq motifs 217A1, 217A2, 217A3, 217A4 et 217A5 sont représentés. Sous réserve que l'épaisseur de chaque motif de résine ait été bien choisie et en tenant compte le cas échéant de l'épaisseur de la couche d'encapsulation 205 et de la couche diélectrique 216, chaque motif 217Ai peut former le coeur d'une cavité de Fabry-Pérot (y-compris à l'endroit où il n'y avait pas de résine qui donne naissance au motif diélectrique 217A5 ; dans ce cas, il convient également de prévoir à cet endroit un transducteur photoélectrique 214A5 sur le substrat 211).

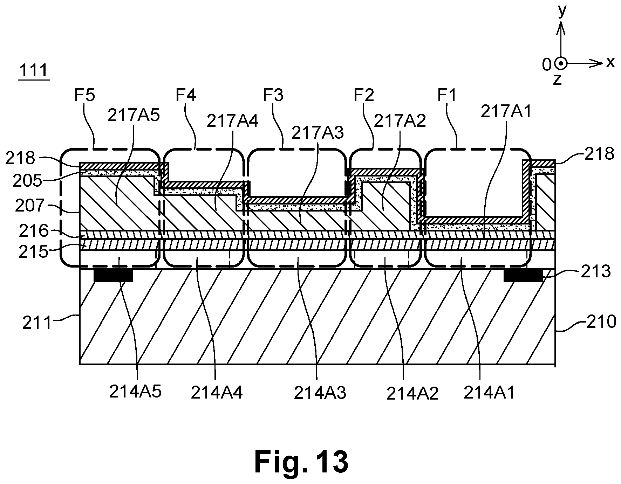

Comme illustré en [Fig. 13], le procédé 100 selon l'invention comporte alors une étape 111 de dépôt d'une couche réfléchissante 218 sur les motifs diélectriques 217Ai de cavité de Fabry-Pérot (ici sur la couche d'encapsulation 205 recouvrant les filtres, étant entendu qu'un retrait de cette couche 205 est aussi possible). Cette couche réfléchissante 218 forme la deuxième couche réfléchissante des filtres de couleurs Fi de type cavité de Fabry-Pérot obtenus selon cette étape (ici cinq filtres F1 à F5). Chaque filtre Fi est formé par une partie de la première couche réfléchissante 215, le motif de diélectrique 217Ai et une partie de la couche réfléchissante 218. Chaque filtre Fi fait face à un transducteur (i.e. un pixel) 214Ai correspondant. La couche réfléchissante 218 est par exemple déposée de façon conforme par dépôt chimique par phase vapeur CVD (Chemical Vapor Déposition en anglais) ou dépôt physique par vapeur PVD (Physical Vapor Déposition). Préférentiellement, la couche 218 est déposée en continue sur l'ensemble des motifs diélectriques 217Ai, y-compris sur les flancs de ces derniers. Avantageusement, l'épaisseur de la couche réfléchissante 218 sera contrôlée pour être constante, a minima sur le dessus des motifs mais également préférentiellement sur les flancs (d'où l'utilisation avantageuse d'un dépôt conforme). Comme déjà évoqué, on constate ici que les cinq filtres de couleur obtenus par le procédé 100 selon l'invention présentent des dimensions librement fixées suivant les trois axes Ox, Oy et Oz, l'épaisseur mesurée selon l'axe Oy fixant le pic de résonnance recherché et les autres dimensions suivant les axes Ox et Oz pouvant être librement fixées selon le confinement de la lumière souhaitée et d'éventuelles contraintes d'encombrement.

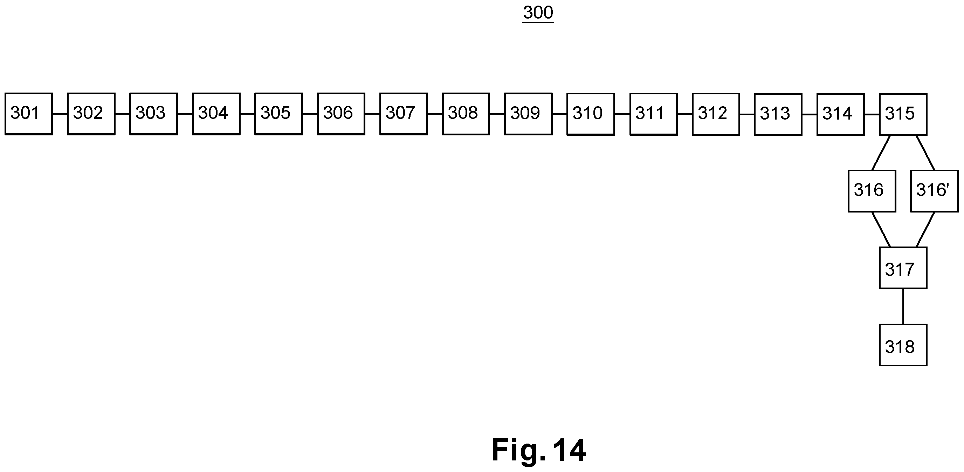

La [Fig. 14] montre une représentation schématique d'un schéma synoptique d'un procédé 300 selon un second mode de réalisation de l'invention. Comme déjà évoqué plus haut, ce second mode de réalisation utilise plusieurs matériaux diélectriques pour la réalisation des cavités de Fabry-Pérot de manière à couvrir une gamme spectrale plus importante, par exemple le visible et l'infrarouge.

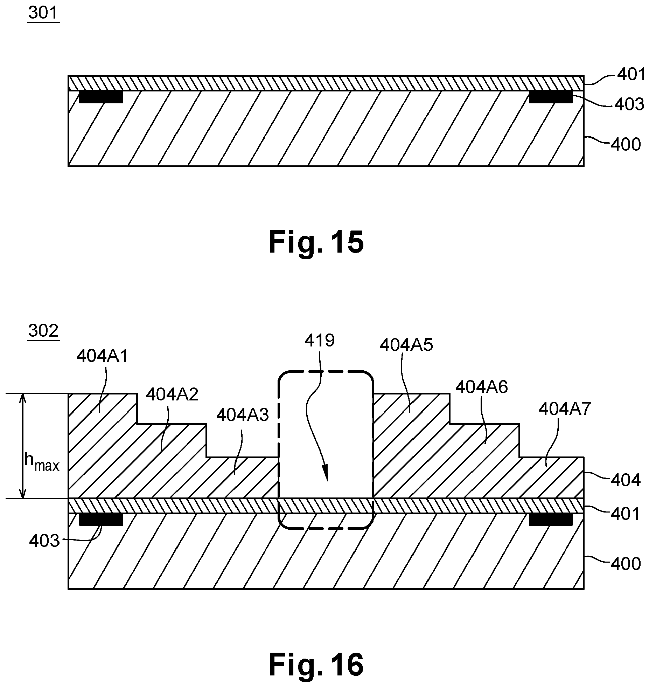

Le procédé 300 comporte une première étape 301 illustrée en [Fig. 15] identique à l'étape 101 de la figure 2, les références 200, 201 et 203 étant respectivement remplacées par les références 400, 401 et 403.

La seconde étape 302 illustrée en [Fig. 16] consiste à déposer une couche de résine 404 puis à structurer en trois dimensions ladite couche de résine 404. La structuration 3D est réalisée par une étape de lithographie. Cette lithographie peut être préférentiellement une lithographie en niveaux de gris ou Grayscale selon la terminologie anglaise électronique ou optique (suivie d'une stabilisation par procédé thermique ou ultraviolet de la résine Grayscale). D'autres techniques de lithographie telles que la lithographie à deux photons ou par nano-impression peuvent également être utilisées pour la réalisation de la structure en résine 404. La structure 404 comporte une pluralité de motifs 404Ai en 3D (ici 6 motifs 404A1, 404A2, 404A3, 404A5, 404A6 et 404A7). Il est possible de fixer librement les dimensions de chaque motif dans les trois directions de l'espace Oxyz (où Oxy est le plan de la figure, l'axe Oy étant selon la direction perpendiculaire au plan du substrat 200 et l'axe Oz étant selon la direction perpendiculaire au plan de la figure).

Selon l'invention, il convient d'avoir au moins deux motifs 404Ai de résine de hauteurs différentes (ici les 4 motifs ont chacun des hauteurs différentes). Parmi l'ensemble de ces motifs 404Ai, au moins l'un d'eux, ici les motifs 404A1 et 404A5, présente une hauteur maximale Hmax, dite de référence, la hauteur étant mesurée perpendiculairement au plan du substrat 400 suivant l'axe Ox. La détermination des hauteurs de chaque motif 404Ai a déjà été expliquée plus haut en référence au premier mode de réalisation du procédé selon l'invention. Selon ce second mode de réalisation et contrairement à la figure 3, on observe ici que l'étape de dépôt et de structuration de la résine a laissé libre un emplacement 419 sur la couche d'arrêt 401. Nous verrons par la suite que cet emplacement 419 est réservé à la création ultérieure d'un second type de cavité de Fabry-Pérot utilisant un autre matériau diélectrique que celui prévu au niveau des emplacements des motifs 404Ai.

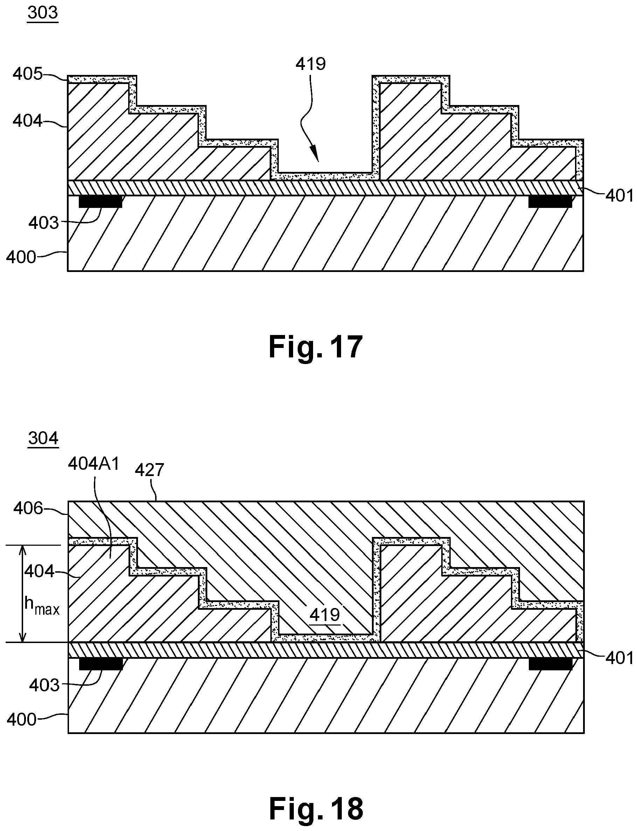

Avantageusement, le procédé 300 selon l'invention comporte une troisième étape 303 illustrée en [Fig. 17] consistant à réaliser un dépôt conforme d'une couche d'encapsulation 405 sur les motifs de résine 404Ai et sur l'emplacement libre 419. Le matériau de la couche d'encapsulation 405 peut être par exemple de l'Al2O3 ou du SiO2 et le dépôt sera préférentiellement réalisé par une technique de dépôt basse température tel qu'un dépôt par couches atomiques ALD (« Atomic Layer Déposition » selon la terminologie anglaise).

Le procédé 300 selon l'invention comporte ensuite une étape 304 illustré en [Fig. 18] visant à déposer une couche 406 réalisée dans le matériau diélectrique destiné à former les motifs diélectriques des cavités de Fabry-Pérot de premier type. La couche 406 de matériau diélectrique recouvre la totalité des motifs de résine 404Ai ainsi que l'emplacement 419 qui est complètement rempli de matériau diélectrique. En d'autres termes, elle présente une surface supérieure 427 (non nécessairement plane) dont chaque point est situé à une hauteur, relativement au substrat poignée, supérieure à la hauteur maximale de référence Hmax. Ainsi, la couche 406 remplit entièrement les vides entre les motifs de résine 204Ai et vient se situer dans sa totalité au-dessus du motif de résine 404A1 le plus haut de la structure. Le matériau de la couche 406 est préférentiellement mais non limitativement un matériau transparent dans le domaine du visible tel qu'un matériau organique du type polymère ou inorganique (oxyde, nitrure de silicium, alumine, ...).

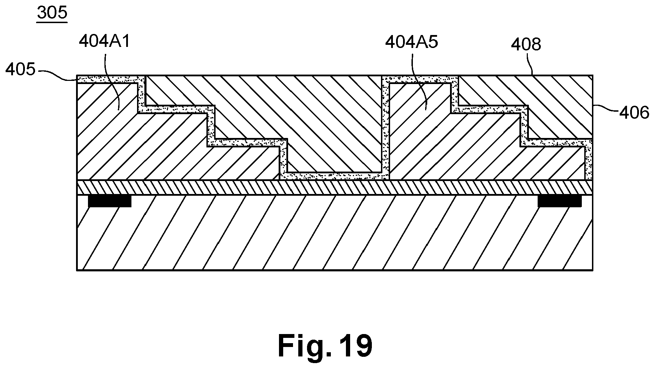

Le procédé 300 comporte alors en [Fig. 19] une étape de planarisation de la couche 406 réalisée dans le matériau diélectrique destiné à former les motifs diélectriques des cavités de Fabry-Pérot d'un premier type de façon à former une couche planarisée en surface par retrait du matériau diélectrique de la couche 406. L'étape de planarisation peut être réalisée par une étape de gravure de type etch-back éventuellement suivie d'une étape de polissage mécano-chimique CMP (Chemical Mechanical Polishing selon la terminologie anglaise). La planarisation s'effectue avec arrêt sur la couche d'encapsulation 405 située à son niveau le plus haut (i.e. au niveau de la hauteur de référence des motif 404A1 et 404A5).

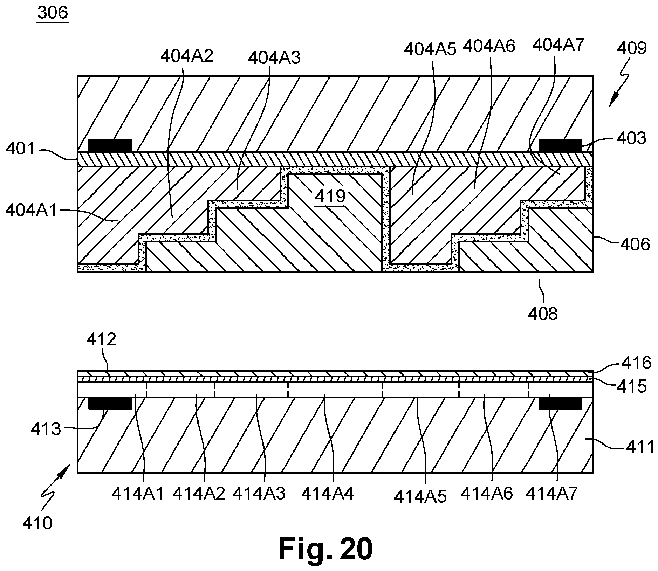

L'étape 306 du procédé 300 représentée en [Fig. 20] consiste à retourner le dispositif 409 obtenu à l'issue de l'étape 305 pour reporter la face planarisée 408 du dispositif 409 formé par le substrat poignée sur la face supérieure 412 d'un substrat, dit substrat porteur 410.

Comme dans le premier mode de réalisation, le substrat porteur 410 comporte un substrat 411 dans lequel sont réalisés des marques d'alignement 213. Ces marques d'alignement 413 vont être placées en regard des marques d'alignement 403 du dispositif 409. Sur le substrat 411 sont formés une pluralité de transducteurs (au moins deux) photoélectriques 414Ai, chacun délimité par des pointillés (ici 7 transducteurs photoélectriques 414A1, 414A2, 414A3, 414A4, 414A5, 414A6 et 414A7 sont représentés). Le substrat porteur 410 comporte par ailleurs au-dessus des transducteurs 414Ai, une couche réfléchissante 415 destinée à former la première couche réfléchissante (ou couche miroir) des filtres de couleurs Fabry-Pérot. Dans le mode de réalisation de la figure 20 et de façon nullement limitative, on dispose au-dessus de la couche réfléchissante 415, une couche diélectrique 416 visant à favoriser le report de la surface planarisée 408 de la couche diélectrique 406.

Lors du report de la face planarisée 408 du dispositif 409 formé par le substrat poignée sur la face supérieure 412 du substrat porteur 410, on utilise avantageusement les marques d'alignement (respectivement 403 et 413) de sorte que chacun des motifs de résine 3D 404Ai et l'emplacement libre 419 soit en regard d'un transducteur photoélectrique 414Ai. En d'autres termes, les motif 404A1, 404A2, 404A3, 404A5, 404A6 et 404A7 sont respectivement en regard des transducteurs 414A1, 414A2, 414A3, 414A5, 414A6 et 414A7. L'emplacement libre 419 est lui en regard du transducteur 414A4.

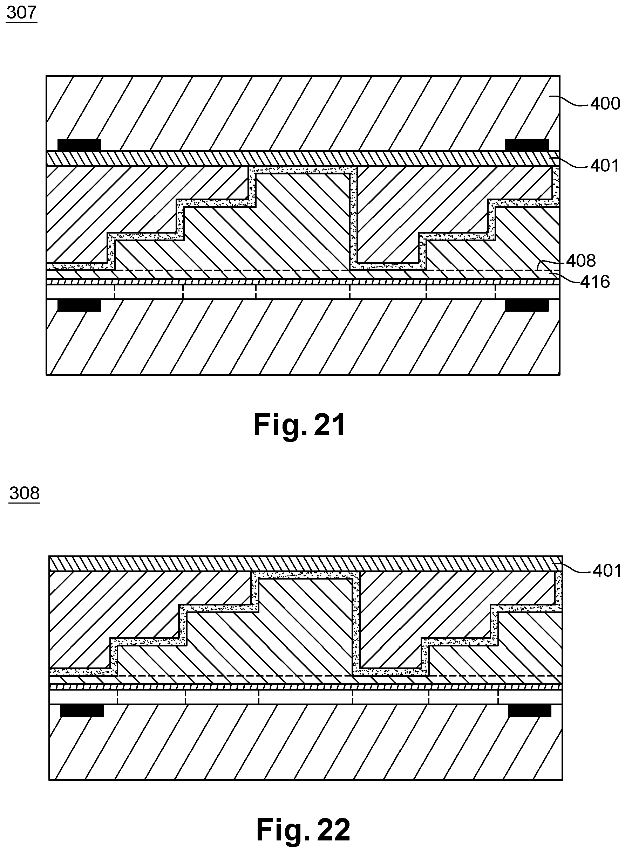

L'étape 307 du procédé 300 représentée en [Fig. 21] est le prolongement de l'étape 306 et vise à coller la surface planarisée 408 de la couche diélectrique 406 sur la surface 412 de la couche diélectrique 416.

Conformément à la [Fig. 22], le procédé 300 selon l'invention comporte une étape 308 de retrait du substrat poignée 400 avec arrêt sur la couche d'arrêt 401 qui sert de couche de protection pour les motifs de résine 404Ai. Cette opération peut être par exemple faite par gravure, polissage de type CMP ou meulage de type grinding.

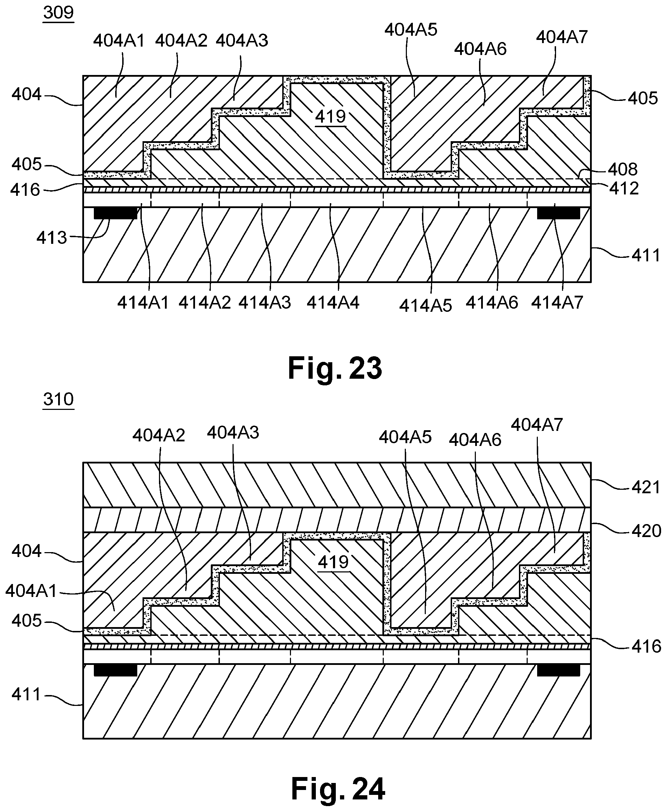

Le procédé 300 comporte ensuite une étape 309 de retrait de la couche d'arrêt 401 illustrée en [Fig. 23], par exemple par un procédé de gravure sèche ou humide de sorte à libérer en surface les motifs de résines 404Ai et l'emplacement libre 419.

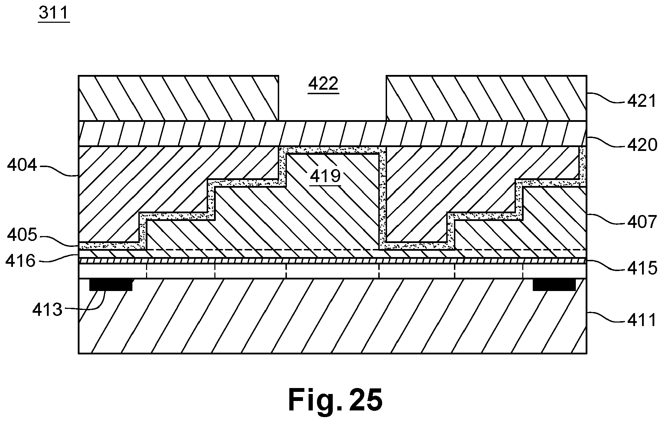

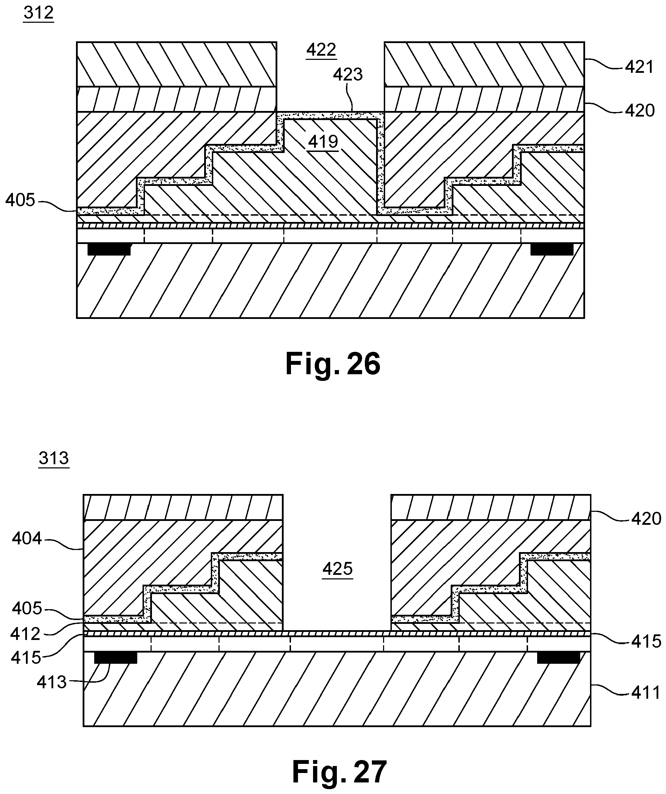

Selon les étape 310 à 312 du procédé 300 selon l'invention, on réalise une opération de photolithogravure en commençant par déposer ou étaler une couche de masque dur 420 (en SiO2 par exemple) au-dessus des motifs 404Ai et de l'emplacement libre 419. Une couche de résine photosensible 421 est ensuite étalée sur la couche de masque dur ([Fig. 24]). Une opération de lithographie connue de l'homme du métier permet d'ouvrir (ouverture 422) la couche de résine 421 à la verticale de l'emplacement libre 419 prévu pour la réalisation d'une cavité de Fabry-Pérot d'un second type ([Fig. 25]). L'ouverture 422 est ensuite transférée de la couche de résine 421 dans le masque dur 420 par gravure ([Fig. 26]) de sorte que l'ouverture 422 surplombe verticalement l'emplacement libre 419. La couche de résine est ensuite retirée.

Selon l'étape 313 du procédé 300 illustrée en figure 27, deux étapes de gravure sèche sont réalisées afin de retirer la partie 423 de la couche d'encapsulation 405 en regard de l'ouverture 422 et le matériau diélectrique destiné à former les cavités de Fabry-Pérot de premier type remplissant l'emplacement libre 419. L'étape de gravure du matériau diélectrique s'arrête sur la couche réfléchissante 415 de façon à former une ouverture vide 425 dans l'emplacement libre 419.

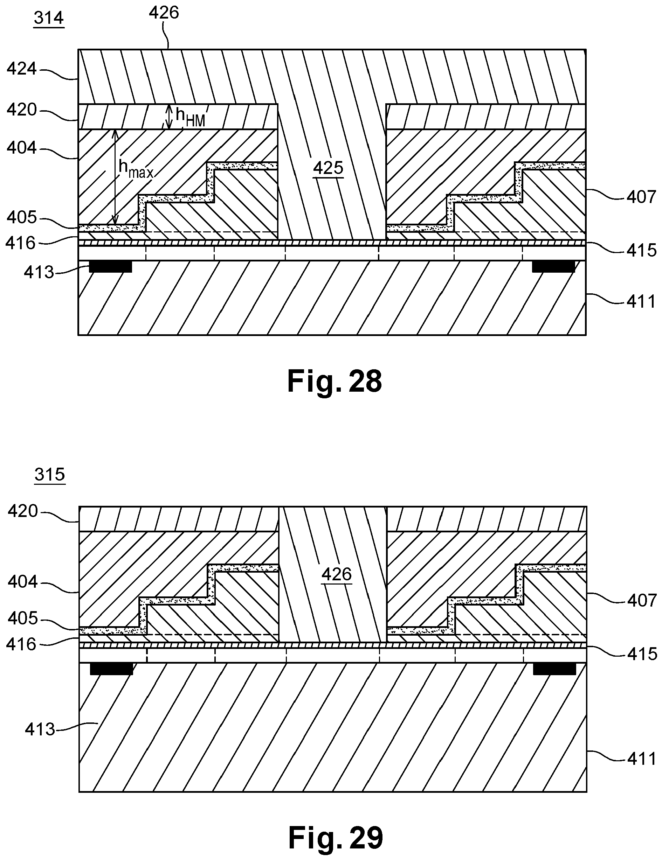

Le procédé 300 selon l'invention comporte ensuite une étape 314 illustrée en [Fig. 28] visant à déposer une couche 424 réalisée dans le matériau diélectrique destiné à former le motif diélectrique d'au moins une cavité de Fabry-Pérot d'un second type. La couche 424 de matériau diélectrique recouvre ici la totalité du masque dur 420 et remplit entièrement l'ouverture 425 en débordant de celle-ci. En d'autres termes, la couche 424 présente une surface supérieure 426 (non nécessairement plane) dont chaque point est situé à une hauteur, relativement au substrat poignée, supérieure à la hauteur maximale de référence Hmax à laquelle on ajoute la hauteur $h_{HM}$ du masque dur 420. Le matériau de la couche 424 peut être un matériau diélectrique organique ou inorganique.

Le procédé 300 comporte alors en [Fig. 29] une étape de planarisation 315 avec arrêt sur le masque dur 420, de la couche 424 réalisée dans le matériau diélectrique destiné à former les motifs diélectriques des cavités de Fabry-Pérot d'un second type de façon à éliminer le matériau diélectrique en excès au-dessus du masque dur 420 et à planariser la surface supérieure du volume de diélectrique remplissant l'ouverture 425 formant ainsi un motif 426 de diélectrique de la cavité électrique d'un second type. L'étape de planarisation peut être réalisée par une étape de gravure de gravure sèche réactive de type RIE (Reactive Ion Etching en anglais) ou une étape de polissage mécano-chimique CMP (Chemical Mechanical Polishing selon la terminologie anglaise).

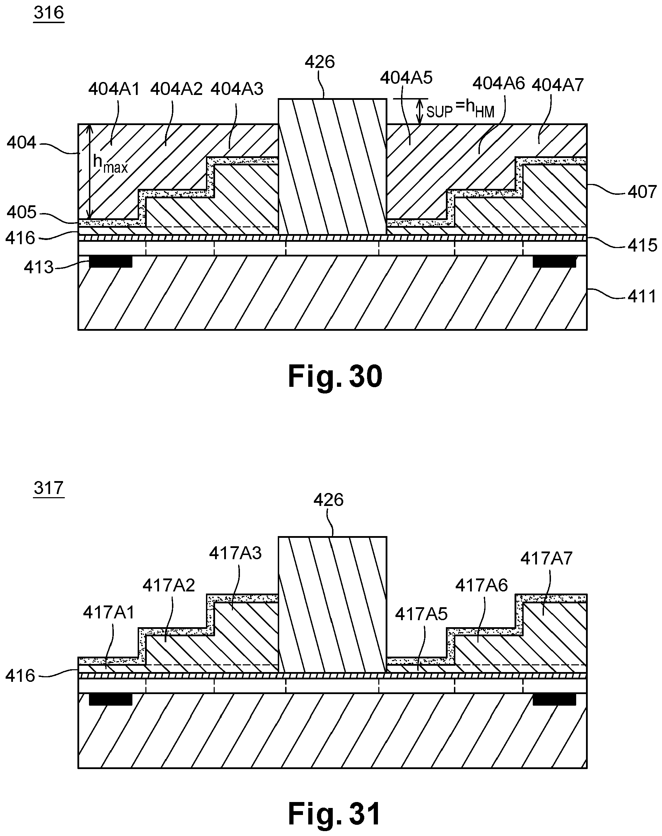

Selon un première variante du procédé 300, ce dernier comporte une étape 316 illustrée en [Fig. 30] consistant à retirer sélectivement le masque dur 420 de manière à laisser dépasser une surépaisseur $h_{sup}$ du motif 426 au-dessus de la couche de résine structurée 404. Cette première variante s'applique lorsque l'indice optique du matériau diélectrique destiné à former les cavités de Fabry-Pérot d'un second type est tel que l'épaisseur des cavités d'un second type doit être supérieure à la hauteur Hmax de la couche de résine 404. Avantageusement, l'épaisseur $h_{sup}$ du motif 426 est inférieure ou égale à l'épaisseur $h_{HM}$ du masque dur 420 (les deux épaisseurs sont sensiblement égales sur la figure 30).

Le procédé 300 comporte ensuite une étape 317 de retrait de la résine 404 (et donc de l'ensemble des motifs 404Ai) illustrée en [Fig. 31] avec arrêt sur la couche d'encapsulation 405, par exemple par une technique de gravure chimique de type stripping.

L'étape 317 permet de libérer en surface les motifs diélectriques 417Ai de cavités de Fabry-Pérot d'un premier type (ici, les six motif 417A1, 417A2, 417A3, 417A5, 417A6 et 417A7 sont représentés) en plus du motif diélectrique 426 de cavité de Fabry-Pérot d'un second type. Sous réserve que l'épaisseur de chaque motif de résine ait été bien choisie et en tenant compte le cas échéant de l'épaisseur de la couche d'encapsulation 405 et de la couche diélectrique 416, chaque motif 417Ai peut former le coeur d'une cavité de Fabry-Pérot d'un premier type et le motif 426 forme le coeur d'une cavité de Fabry-Pérot d'un second type.

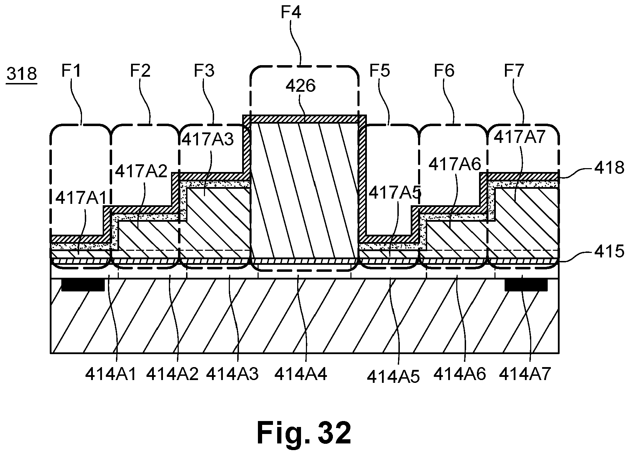

Comme illustré en [Fig. 32], le procédé 300 selon l'invention comporte alors une étape 318 de dépôt d'une couche réfléchissante 418 sur les motifs diélectriques 417Ai de cavité de Fabry-Pérot d'un premier type (ici sur la couche d'encapsulation 205 recouvrant les motifs) et sur le motif diélectrique 426 de cavité d'un second type. Cette couche réfléchissante 418 forme la deuxième couche réfléchissante des filtres de couleurs Fi de type cavité de Fabry-Pérot obtenus selon cette étape : ici six filtres F1, F2, F3, F5, F6 à F7 d'un premier type et un filtre F4 d'un second type). Il est entendu que nous avons illustré ce mode à travers la réalisation d'un seul filtre de second type mais il est également possible de d'obtenir plusieurs filtres de second type (notamment en laissant plusieurs emplacements laissés libre lors de l'étape 301 représentés en figure 16). Chaque cavité d'un premier type utilise le même matériau diélectrique et présente une épaisseur prédéterminée permettant un filtrage spécifique. La cavité F4 d'un second type utilise un autre matériau diélectrique et, grâce à ce matériau différent, permet un filtrage spectral spécifique différent des cavités de premier type.

Chaque filtre Fi est formé par une partie de la première couche réfléchissante 415, le motif de diélectrique et une partie de la couche réfléchissante 418. Chaque filtre Fi fait face à un transducteur photoélectrique 414Ai correspondant. La couche réfléchissante 418 est par exemple déposée de façon conforme par dépôt chimique par phase vapeur CVD (Chemical Vapor Déposition en anglais) ou dépôt physique par vapeur PVD (Physical Vapor Déposition).

Une seconde variante du procédé 300 peut être envisagée à la suite de l'étape de planarisation 315, lorsque l'indice optique du matériau diélectrique destiné à former les cavités de Fabry-Pérot d'un second type est tel que l'épaisseur des cavités d'un second type $H_{FP2}$ doit être inférieure à la hauteur Hmax de la couche de résine 404.

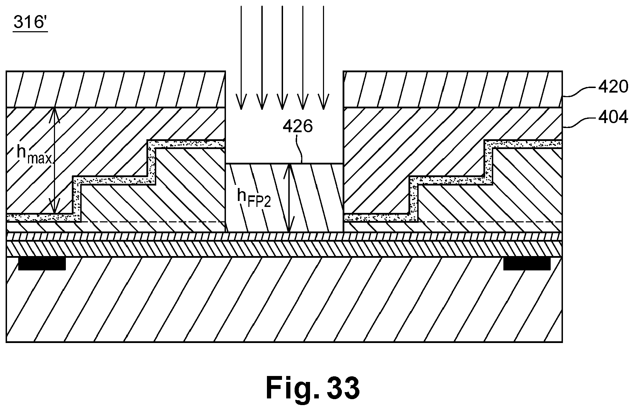

Le procédé comporte alors une étape 316' illustrée en [Fig. 33] suivant l'étape 315 et consistant à graver sélectivement le matériau diélectrique de second type par rapport au masque dur 420 jusqu'à l'obtention de l'épaisseur $h_{FP2}$ du motif 426' souhaité. Une fois cette étape réalisée, on retire le masque dure 420 et les étapes suivantes sont identiques aux étapes 317 à 318 (retrait de la résine et dépôt d'une couche réfléchissante formant la deuxième couche réfléchissante des filtres de couleurs de type cavité de Fabry-Pérot de premier et second type).

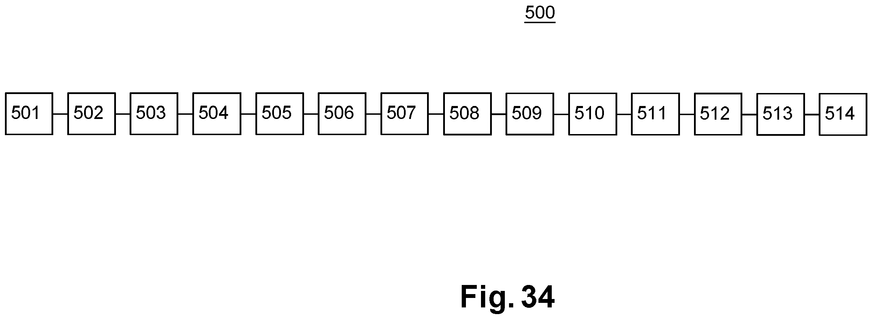

La [Fig. 34] montre une représentation schématique d'un schéma synoptique d'un procédé 500 selon un troisième mode de réalisation de l'invention. Ce troisième mode de réalisation est particulièrement adapté lorsque les dimensions des pixels et donc des filtres de couleur se réduisent, typiquement de l'ordre de la longueur d'onde de la lumière. Le recouvrement spatial des contributions lumineuses d'une cavité de Fabry-Pérot à l'autre, peut dégrader l'efficacité du dispositif global. Ce phénomène de « crosstalk » a déjà été observé pour les transducteurs photoélectriques (i.e. les capteurs CMOS). Au cours des dernières années, les dimensions des pixels n'ont en effet cessé de se réduire, ceci afin de proposer des capteurs à haute résolution, pour les Smartphones notamment. Cette réduction de dimensions des pixels a deux conséquences bien distinctes :

- La quantité totale de lumière incidente arrivant sur chaque pixel décroit, impliquant que de moins en moins de photons atteignent le composant photosensible. La collection et le bon guidage de chaque photon au sein du composant vers le capteur est d'autant plus importante pour garantir la bonne l'efficacité du capteur.

- Lorsque la taille du pixel se rapproche de la longueur de la lumière à collecter, la diffraction entre en jeu, ce qui accroit les pertes optiques et spatiales dans le dispositif.

Accompagnant les problématiques liées à la réduction des dimensions des pixels, l'angle d'incidence avec lequel la lumière pénètre dans la cavité de Fabry-Pérot est également un élément à ne pas négliger. En effet, lorsque des rayons lumineux obliques atteignent la surface des cavités, une certaine partie de la lumière passe à travers la bordure physique du filtre, pour venir terminer sa course dans la cavité voisine. Cette contribution indésirable, parasite, fausse la collection de lumière à l'échelle du dispositif, et est une autre source importante dans le « crosstalk » d'un pixel à l'autre.

Les cinq premières étapes 501 à 505 sont identiques aux cinq premières étapes 101 à 105 du procédé illustrées aux figures, 2, 3, 4, 6 et 7 (par soucis de simplification, les mêmes références sont reprises pour les éléments communs aux figures 2, 3, 4, 6 et 7).

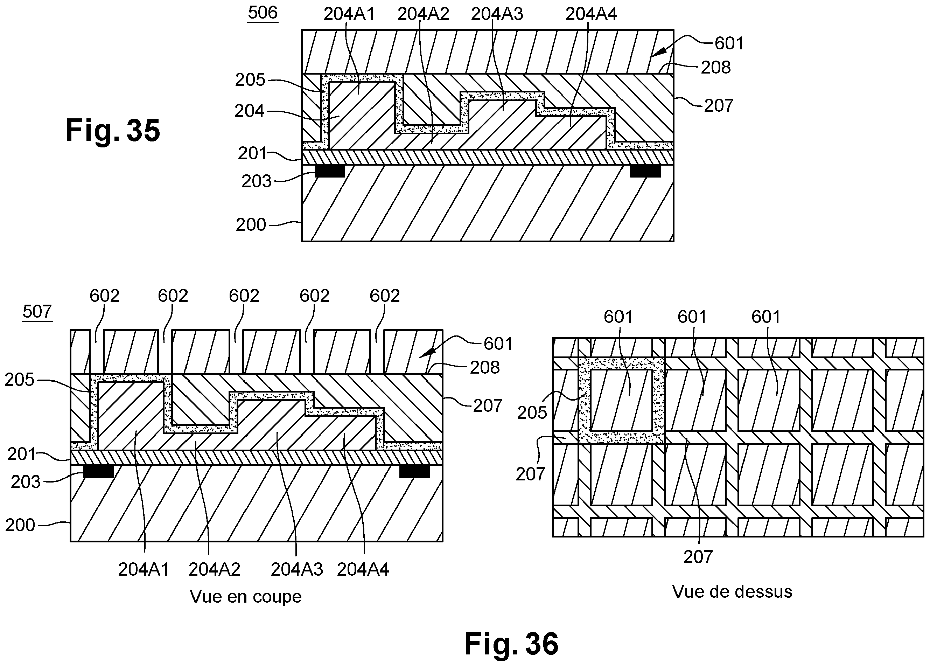

La sixième étape 506 du procédé 500 est illustrée en [Fig. 35] consiste à déposer ou étaler sur la couche planarisée 207 du matériau diélectrique destiné à former les motifs des cavités de Fabry-Pérot et la couche 205 d'encapsulation, une couche de résine 601 photosensible ou électrosensible.

Le procédé 500 selon l'invention comporte alors en [Fig. 36] une étape 507 de photolithographie consistant à créer des tranchées 602 alignées avec les bordures des futures cavités de Fabry-Pérot. Pour ce faire, la couche de résine photo ou électrosensible 601 est exposée à l'aide d'un équipement de lithographie, afin de définir à sa surface un quadrillage régulier de tranchée après développement de la résine (espaces ouverts dans la résine jusqu'au matériau diélectrique 207 ou jusqu'à la couche d'encapsulation 205).

La vue de dessus de la figure 36 permet de montrer le quadrillage régulier des tranchées de résine 602, les parties de la couche diélectrique 207 vues à-travers les tranchées 602 et la partie de la couche d'encapsulation 205 correspondant au motif de résine 204A1. On notera que la représentation des motifs sous forme de carrés n'est donnée qu'à titre illustratif. Comme expliqué à plusieurs reprises plus haut dans la description, les dimensions des motifs peuvent être à la fois différents d'un motif à l'autre et rien n'oblige par ailleurs que le motif soit carré en vue de dessus (il pourrait s'agir d'un motif rectangulaire par exemple).

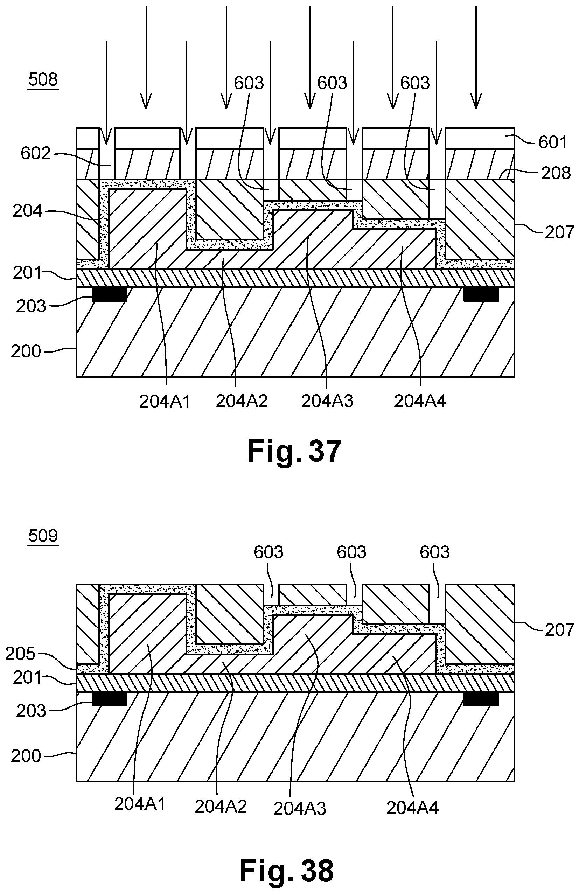

Le procédé 500 selon l'invention comporte alors en [Fig. 37] une étape 508 de photolithographie consistant à transférer par gravure sèche ou humide les tranchées ou espaces ouverts 602 précédemment réalisées dans la couche 207 de matériau diélectrique des futures cavités de Fabry-Pérot avec arrêt sur la couche d'encapsulation 205 de la couche de résine structurée 204. Ce transfert permet de réaliser un quadrillage identique dans la couche diélectrique 207 avec des tranchées 603 sensiblement alignées sur les flancs de la couche d'encapsulation 205. Chaque tranchée reportée définit ainsi les bords extérieurs de chaque cavité filtrante. Le reste de résine superficielle 601 éventuellement non consommée au terme de la gravure est le cas échéant enlevé, par exemple par un procédé de nettoyage de type stripping (étape 509 illustrée en [Fig. 38]). Il convient de noter que la dimension des tranchées 603 ainsi ouvertes dans le matériau diélectrique 207 pourra être pris en compte, si besoin, dans le dimensionnement latéral (encombrement) des futures cavités de Fabry-Pérot.

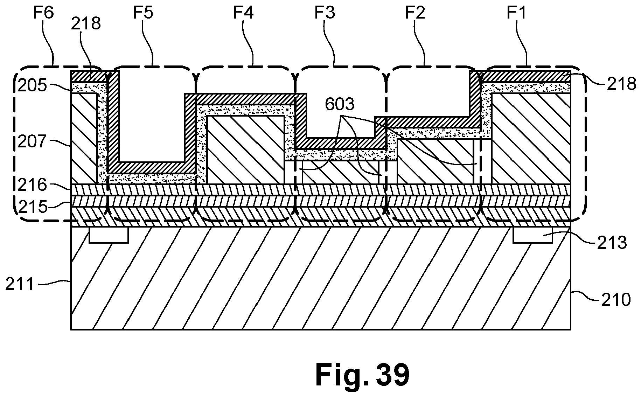

Les étapes 510, 511, 512, 513 et 514 sont respectivement identiques aux étapes 106, 107, 108, 109 et 110 illustrées aux figures 8 à 12 et permettent d'aboutir au dispositif illustré en [Fig. 39]. Ce dispositif est quasiment identique au dispositif de la figure 13 à la différence qu'il comporte des tranchées d'air ou « air gap » (selon la terminologie anglaise) 603 présentant un indice optique bas et qui sert de barrière de confinement pour la lumière au sein des cavités de Fabry-Pérot. Comme en figure 13, la couche réfléchissante 218 forme la deuxième couche réfléchissante des filtres de couleurs Fi de type cavité de Fabry-Pérot obtenus selon cette étape (ici six filtres F1 à F6). Chaque filtre Fi est formé par une partie de la première couche réfléchissante 215, le motif de diélectrique et une partie de la couche réfléchissante 218. Chaque filtre Fi fait face à un transducteur (i.e. un pixel) correspondant.

Grâce à ce troisième mode de réalisation et à la présence des « air-gap » 603, on limite considérablement les problématiques de « crosstalk » précédemment mentionnées lorsque les dimensions des cavités de Fabry-Pérot deviennent de l'ordre de la longueur d'onde de la lumière, en augmentant ainsi l'efficacité du dispositif global. La tranche d'air ceinturant chaque cavité de Fabry-Pérot permet donc d'aboutir à un dispositif de filtrage multispectral à l'aide de cavités de Fabry-Pérot isolées les unes des autres. Il convient de noter qu'avantageusement, des tranches d'air peuvent également entourer les transducteurs photoélectriques également soumis aux mêmes problématiques de crosstalk.

Un quatrième mode de réalisation du procédé selon l'invention peut consister à remplacer les tranches d'air par des murs d'isolation optique, lesdits murs étant réalisés dans des matériaux à bas indice de réfraction optique, lesdits murs entourant les cavités de Fabry-Pérot de sorte à limiter le « crosstalk » entre elles. On notera que ce type de solution (« air-gap » ou mur d'isolation) a déjà été mis en oeuvre autour des transducteurs photoélectriques (photodiode) mais pas au niveau du filtre comme cela est proposé dans la présente invention. On pourra utiliser pour les matériaux des murs d'isolation des matériaux ayant un indice optique compris entre 1.25 et 1.4 (comme la référence Low-n polymer SLS-B047A de la société de Fujifilm™ ayant un indice n = 1.25 à 550nm). Avantageusement, il convient d'utiliser un polymère qui présente un indice optique compris entre 1.25 et 1.4 (sachant que l'indice optique moyen d'un polymère est de l'ordre de 1.5). Usuellement, ce sont des polymères qui présentent des groupements fluorés. Un grand nombre de matériaux de ce type existent déjà pour des applications optiques. On peut citer à titre d'exemples de polymères présentant des groupements fluorés le Poly(hexafluoropropylene oxide), le Fluorinated Ethylene Propylene, le Poly(tetrafluoroethylene) ou le Poly(octafluoropentyl acrylate). On peut également citer quelques exemples de polymères non fluorés tels que le Poly(methyl hydro siloxane) ou le Hydroxypropyl cellulose.

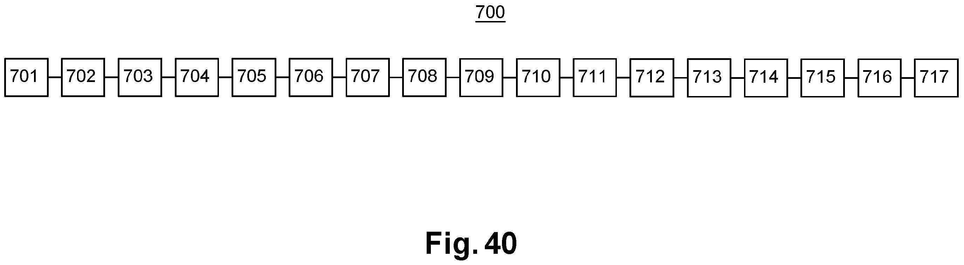

Le procédé 700 selon ce quatrième mode de réalisation est représenté en [Fig. 40]. Les huit premières étapes 701 à 709 sont respectivement identiques aux huit premières étapes 501 à 509 du procédé 500 précédemment décrit.

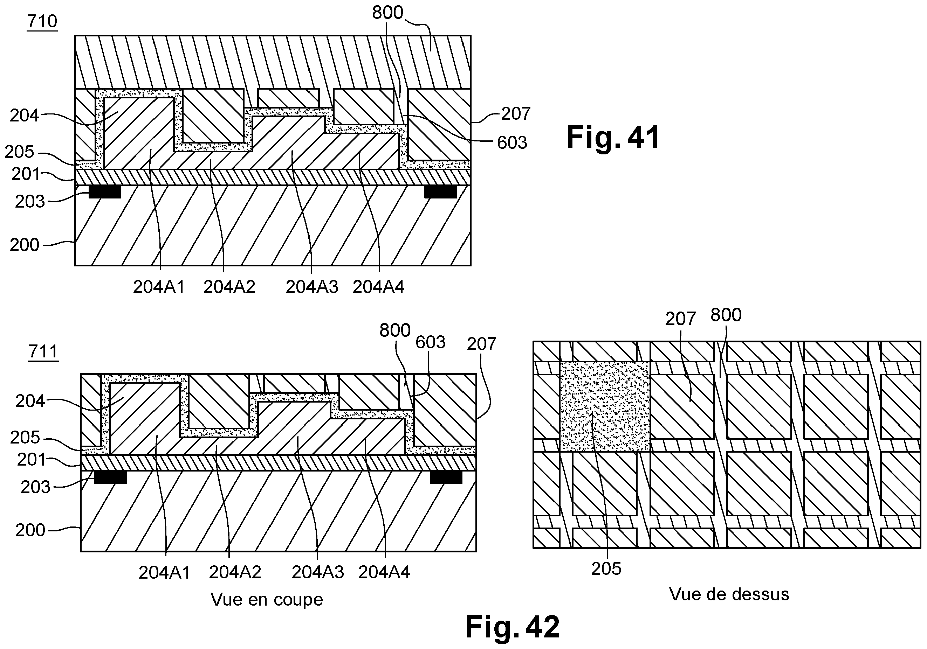

L'étape 710 illustrée en [Fig. 41] consiste à déposer ou étaler un matériau 800 à bas indice optique (i.e. un indice optique inférieur strictement à l'indice optique du matériau diélectrique de la couche 207 destiné à former la cavité de Fabry-Pérot). Le matériau 800 vient remplir les tranchées 603 préalablement créées. On notera, comme c'est le cas sur la figure 41, que le remplissage par le matériau 800 peut être fait avec excès au-dessus de la surface formée par les motifs de résine 204 et la couche d'encapsulation 205.

L'étape 711 illustrée en [Fig. 42] consiste à planariser la surface en retirant l'excès du matériau 800 pour laisser ce dernier uniquement dans les tranchées 603.

La vue de dessus de la figure 42 permet de montrer le quadrillage régulier des tranchées remplies du matériau 800, les parties de la couche diélectrique 207 vues à-travers les tranchées 602 et la partie de la couche d'encapsulation 205 correspondant au motif de résine 204A1.

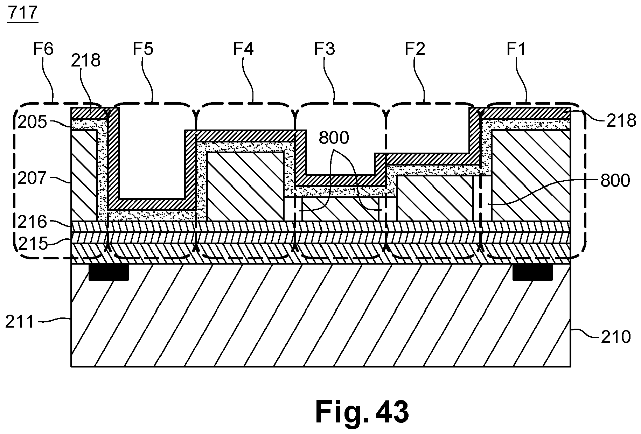

Les étapes 712, 713, 714, 715 et 716 sont respectivement identiques aux étapes 106, 107, 108, 109 et 110 illustrées aux figures 8 à 12 et permettent d'aboutir au dispositif illustré en [Fig. 43]. Ce dispositif est quasiment identique au dispositif de la figure 39 à la différence que les tranchées d'air ou « air gap » sont remplacées par des tranchées remplies du matériau 800 présentant un indice optique plus bas que celui du matériau diélectrique utilisé pour les cavités de Fabry-Pérot et qui sert de barrière de confinement pour la lumière au sein desdites cavités. Comme en figure 39, la couche réfléchissante 218 forme la deuxième couche réfléchissante des filtres de couleurs Fi de type cavité de Fabry-Pérot obtenus selon cette étape (ici six filtres F1 à F6). Chaque filtre Fi est formé par une partie de la première couche réfléchissante 215, le motif de diélectrique et une partie de la couche réfléchissante 218. Chaque filtre Fi fait face à un transducteur (i.e. un pixel) correspondant.

Comme mentionné précédemment, la présence des murs en matériau 800 vise à renforcer l'efficacité optique des cavités filtrantes de Fabry-Pérot grâce à l'intégration de ces murs d'isolation et de confinement optique à chaque cavité.

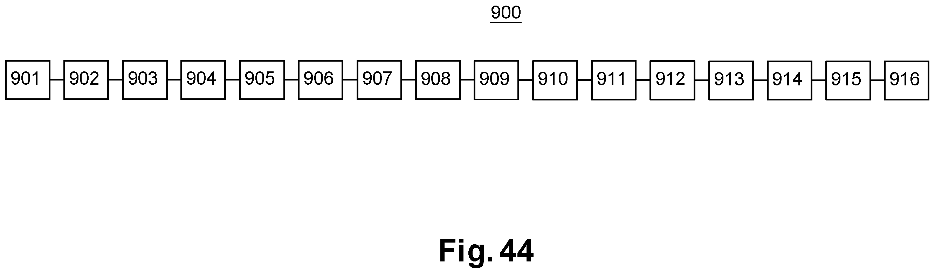

On constate que dans le mode de réalisation précédent, les murs d'isolation sont réalisés après le dépôt du matériau diélectrique destiné à former le coeur des cavités de Fabry-Pérot. Selon un cinquième mode de réalisation du procédé selon l'invention (procédé 900 en [Fig. 44]), il est également possible de commencer par réaliser le dépôt du matériau à bas indice optique et le structurer en murs d'isolation avant la réalisation et la structuration du matériau diélectrique définissant les cavités de Fabry-Pérot.

Les trois premières étapes 901, 902 et 903 du procédé 900 sont respectivement identiques aux étapes 101, 102 et 103 du procédé 100 illustrées aux figures 2, 3 et 5.

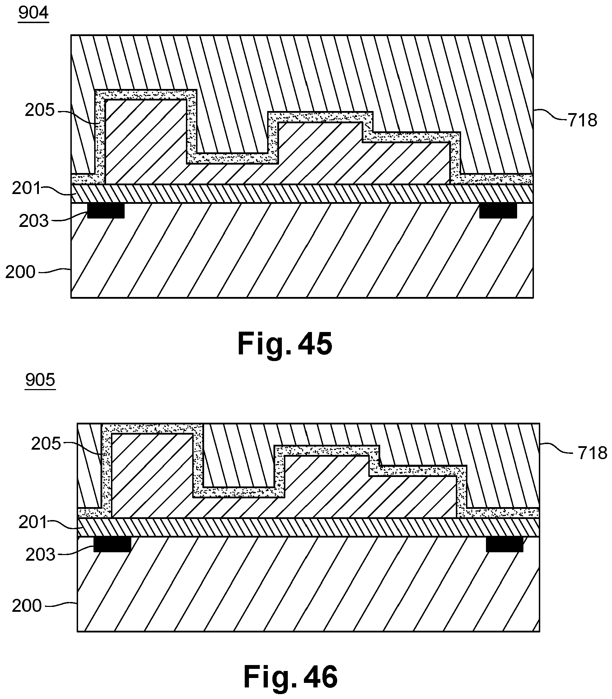

L'étape 904 illustrée en [Fig. 45] consiste à déposer ou étaler le matériau 718 à bas indice optique (i.e. un indice optique inférieur strictement à l'indice optique du matériau diélectrique destiné à former la cavité de Fabry-Pérot et non encore déposé) sur la couche d'encapsulation 205.

L'étape 904 est suivie de l'étape 905 illustrée en [Fig. 46] durant laquelle on planarise la couche 718 avec un arrêt sélectif au sommet de la couche d'encapsulation 205. Cette étape de planarisation peut être réalisée par une étape de gravure de type etch-back éventuellement suivie d'une étape de polissage mécano-chimique CMP (Chemical Mechanical Polishing selon la terminologie anglaise).

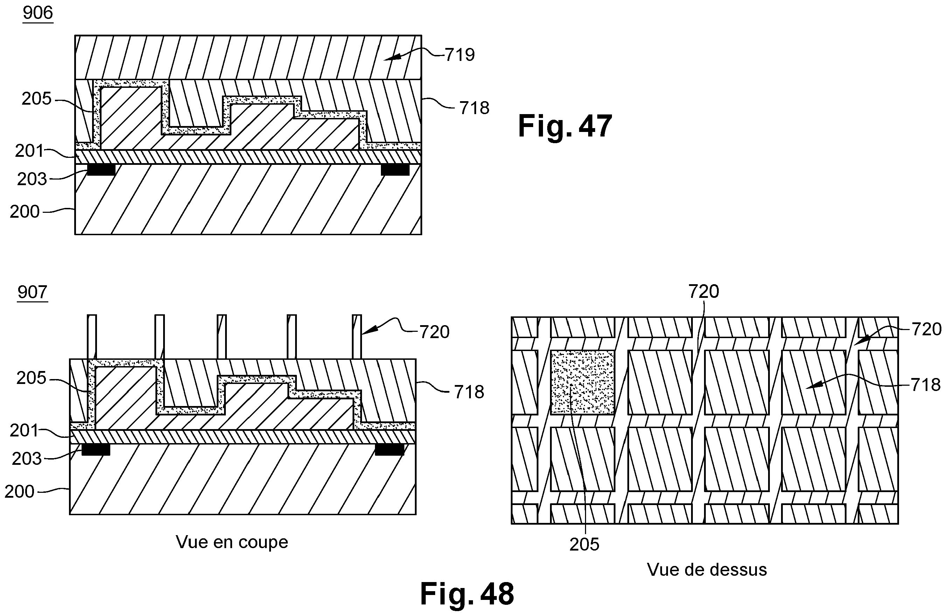

Le procédé 900 comporte alors une étape 906 illustrée en [Fig. 47] consistant à déposer ou étaler une couche de résine 719 photo ou électrosensible au-dessus de la couche 718 planarisée de matériau à bas indice optique.

L'étape suivante 907 illustrée en [Fig. 48] vise à exposer ladite couche de résine 719 à un système de photolithographie pour structurer un réseau sous forme de quadrillage de lignes 720 après le développement de la résine, les lignes étant disposées à l'aplomb des bords ou flancs des futures cavités de Fabry-Pérot (ici, les lignes sont alignées avec les flancs de la couche d'encapsulation 205).

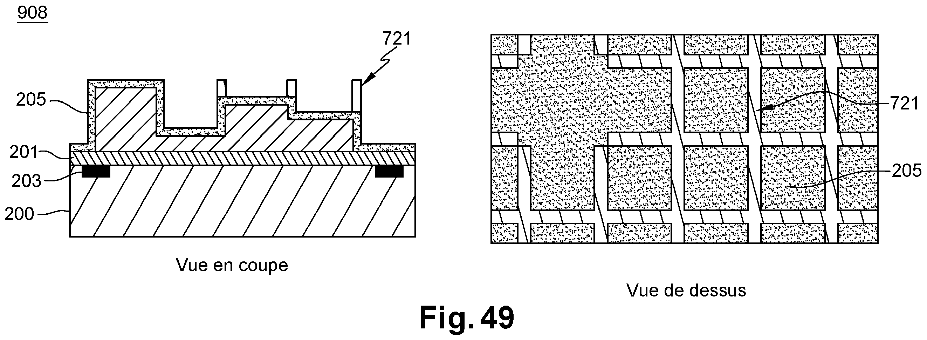

Le procédé 900 comporte alors une étape 908 illustrée en [Fig. 49] dans laquelle on réalise une gravure sèche ou humide de la couche 718 planarisée de matériau à bas indice optique en transférant les lignes 720 de résine précédemment réalisées dans la couche 718. On forme ainsi un quadrillage de lignes 721 du matériau à bas indice optique identique au quadrillage de résine obtenu à l'issue de l'étape 907.

On notera que la dimension (largeur) des lignes formant les murs d'isolation, ainsi transférées dans le matériau à bas indice optique, pourra être pris en compte, si besoin, dans le dimensionnement latéral (encombrement) des cavités de Fabry-Pérot.

Les étapes suivantes 909, 910, 911, 912, 913, 914, 915 et 916 du procédé 900 sont identiques aux étapes 104, 105, 106, 107, 108, 109, 110 et 111 du procédé 100 selon l'invention et permettent d'aboutir à un dispositif tel que celui présenté en figure 43.

## Revendications

1. Procédé (100) de fabrication d'un filtre multispectral pour une radiation électromagnétique, ledit filtre comportant au moins deux filtres (Fi) de couleur, chaque filtre comportant une première couche réfléchissante (215), une deuxième couche réfléchissante (218), une couche en matériau diélectrique (207) de cavité de Fabry-Pérot entre la première couche réfléchissante (215) et la deuxième couche réfléchissante (218), l'épaisseur de la couche diélectrique des deux filtres de couleurs étant différente et chacun des deux filtres (Fi) étant en regard d'un transducteur photoélectrique (214Ai), ledit procédé comportant les étapes suivantes :

   - Dépôt (102) sur un substrat (200), dit substrat poignée, d'une couche de résine (204) ;
   - Structuration (102) en trois dimensions de la couche de résine (204) par lithographie de sorte à obtenir au moins deux motifs de résines (204Ai) de hauteurs différentes, au moins un des motifs présentant une hauteur maximale de référence (Hmax), la hauteur étant mesurée perpendiculairement au plan du substrat (200) ;
   - Dépôt (104) d'une couche (206) réalisée dans le matériau diélectrique destiné à former les motifs diélectriques des cavités de Fabry-Pérot, ladite couche (206) de matériau diélectrique recouvrant la totalité des motifs de résine (204Ai) en présentant une surface supérieure (219) dont chaque point est situé à une hauteur relativement au substrat poignée (200) supérieure à la hauteur maximale de référence (Hmax) ;
   - Planarisation (105) par retrait du matériau diélectrique avec arrêt sélectif au sommet du motif de résine le plus haut ;
   - Report (106, 107) de la face planarisée (208) du substrat poignée sur la face supérieure (212) d'un substrat (210), dit substrat porteur, comportant au moins deux transducteurs photoélectriques (214Ai), chacun desdits motifs étant en regard d'un transducteur photoélectrique, une couche réfléchissante (215) destinée à former la première couche réfléchissante des deux filtres de couleurs étant positionnée à l'interface de report entre le substrat poignée et le substrat porteur ;
   - Retrait (108) du substrat poignée (200) ;
   - Retrait (110) de la résine (204) de sorte à libérer en surface au moins deux motifs diélectriques (217Ai) de cavités de Fabry-Pérot d'épaisseur différente ;
   - Dépôt (111) d'une couche réfléchissante (218) sur les au moins deux motifs diélectriques de cavité de Fabry-Pérot, formant la deuxième couche réfléchissante des deux filtres de couleurs.

2. Procédé selon la revendication 1 **caractérisé en ce que** l'étape de structuration est suivie, avant le dépôt de la couche réalisée dans le matériau diélectrique destiné à former les motifs diélectriques des cavités de Fabry-Pérot, d'une étape de dépôt conforme d'une couche d'encapsulation sur les motifs de résine.

3. Procédé selon l'une des revendications précédentes **caractérisé en ce que** la lithographie utilisée pour l'étape de structuration est une lithographie en niveaux de gris dite Grayscale.

4. Procédé selon l'une des revendications précédentes **caractérisé en ce que** la couche réfléchissante destinée à former la première couche réfléchissante des filtres de couleurs est préalablement déposée sur le substrat porteur au-dessus des transducteurs photoélectriques.

5. Procédé selon la revendication précédente **caractérisé en ce qu'**une couche de matériau diélectrique est déposée sur ladite couche réfléchissante du substrat porteur de façon à assurer un contact diélectrique/diélectrique lors du report de la face planarisée du substrat poignée sur la face supérieure du substrat porteur.

6. Procédé selon l'une des revendications précédentes **caractérisé en ce qu'**il comporte une étape de réalisation de marques d'alignement, lesdites marques d'alignement étant réalisées dans le substrat poignée ou dans la couche de résine, des marques d'alignement étant également présentes dans le substrat porteur de façon à assurer la mise en regard de chacun des motifs de résine avec un transducteur photoélectrique.

**7.** Procédé selon l'une des revendications précédentes **caractérisé en ce qu'**il comporte une étape de dépôt d'une couche d'arrêt préalable à l'étape de dépôt de la couche de résine, le retrait du substrat poignée s'arrêtant sur ladite couche d'arrêt et étant suivi du retrait de la couche d'arrêt de sorte à libérer en surface la couche de résine structurée.

**8.** Procédé selon l'une des revendications précédentes **caractérisé en ce qu'**il comporte une étape de réalisation de murs d'air séparant les motifs diélectriques de cavités de Fabry-Pérot.

**9.** Procédé selon l'une des revendications 1 à 7 **caractérisé en ce qu'**il comporte une étape de réalisation de murs de matériau présentant un indice de réfraction optique strictement inférieur à l'indice de réfraction du matériau diélectrique destiné à former les motifs diélectriques des cavités de Fabry-Pérot, lesdits murs séparant les motifs diélectriques des cavités de Fabry-Pérot.

**10.** Procédé selon l'une des revendications précédentes **caractérisé en ce qu'**il comporte, en plus de la réalisation d'au moins deux filtres de couleurs, chaque filtre comportant une première couche réfléchissante, une deuxième couche réfléchissante, une couche en matériau diélectrique de cavité de Fabry-Pérot entre la première couche réfléchissante et la deuxième couche réfléchissante, la réalisation d'au moins un autre filtre de couleur comportant une première couche réfléchissante, une deuxième couche réfléchissante, une couche en matériau diélectrique de cavité de Fabry-Pérot, dite d'un second type, entre la première couche réfléchissante et la deuxième couche réfléchissante, le matériau diélectrique de cet autre filtre de couleur étant différent du matériau diélectrique des deux filtres de couleur.

**11.** Procédé selon la revendication précédente **caractérisé en ce que** ladite étape de structuration en trois dimensions de la couche de résine par lithographie est réalisée de sorte à obtenir un emplacement libre dans lequel est déposée le matériau diélectrique destiné à former le motif de la cavité de Fabry-Pérot d'un second type.

**Patentansprüche**

**1.** Verfahren (100) zur Herstellung eines multispektralen Filters für elektromagnetische Strahlung, wobei der Filter mindestens zwei Farbfilter (Fi) umfasst und jeder Filter eine erste reflektierende Schicht (215), eine zweite reflektierende Schicht (218), eine Schicht aus dielektrischem Material (207) eines Fabry-Pérot-Hohlraums zwischen der ersten reflektierenden Schicht (215) und der zweiten reflektierenden Schicht (218) umfasst, wobei die Dicke der dielektrischen Schicht der beiden Farbfilter unterschiedlich ist und jeder der beiden Filter (Fi) einem photoelektrischen Wandler (214Ai) gegenüberliegt, wobei das Verfahren die folgenden Schritte umfasst:

- Auftragen (102) einer Harzschicht (204) auf einem Substrat (200), dem sogenannten Griffsubstrat;
- Dreidimensionale Strukturierung (102) der Harzschicht (204) durch Lithografie, so dass mindestens zwei Harzmuster (204Ai) mit unterschiedlichen Höhen erhalten werden, wobei mindestens eines der Muster eine maximale Bezugshöhe (Hmax) aufweist, wobei die Höhe senkrecht zur Ebene des Substrats (200) gemessen wird;
- Auftragen (104) einer Schicht (206) aus dem dielektrischen Material zur Bildung der dielektrischen Muster der Fabry-Pérot-Hohlräume, wobei die Schicht (206) aus dielektrischem Material alle Harzmuster (204Ai) bedeckt und eine Oberfläche (219) aufweist, auf der alle Punkte in einer Höhe relativ zum Griffsubstrat (200) liegen, die größer ist als die maximale Bezugshöhe (Hmax);
- Planarisierung (105) durch Entfernen des dielektrischen Materials mit selektivem Stopp an der Spitze des obersten Harzmusters;
- Übertragen (106, 107) der planarisierten Fläche (208) des Griffsubstrats auf die Oberseite (212) eines Substrats (210), des sogenannten Trägersubstrats, mit mindestens zwei photoelektrischen Wandlern (214Ai), wobei jedes dieser Muster einem photoelektrischen Wandler gegenüberliegt, wobei eine reflektierende Schicht (215), die dazu bestimmt ist, die erste reflektierende Schicht der beiden Farbfilter zu bilden, an der Übertragungsschnittstelle zwischen dem Griffsubstrat und dem Trägersubstrat positioniert ist;
- Entfernen (108) des Griffsubstrats (200);
- Entfernen (110) des Harzes (204), so dass an der Oberfläche mindestens zwei dielektrische Muster (217Ai) von Fabry-Pérot-Hohlräumen unterschiedlicher Dicke freigesetzt werden;
- Auftragen (111) einer reflektierenden Schicht (218) auf den mindestens zwei dielektrischen Fabry-Pérot-Hohlraummustern, die die zweite reflektierende Schicht der beiden Farbfilter bilden.

**2.** Verfahren nach Anspruch 1, **dadurch gekenn-**

zeichnet, dass** auf den Strukturierungsschritt vor dem Aufbringen der Schicht aus dielektrischem Material, das dazu bestimmt ist, die dielektrischen Muster der Fabry-Pérot-Hohlräume zu bilden, ein Schritt des konformen Aufbringens einer Einkapselungsschicht auf die Harzmuster folgt.

3. Verfahren nach einem der vorhergehenden Ansprüche, **dadurch gekennzeichnet, dass** die für den Strukturierungsschritt verwendete Lithografie eine sogenannte Grayscale-Lithografie (Graustufenlithografie) ist.

4. Verfahren nach einem der vorhergehenden Ansprüche, **dadurch gekennzeichnet, dass** die reflektierende Schicht zur Bildung der ersten reflektierenden Schicht der Farbfilter zuvor auf dem Trägersubstrat über den photoelektrischen Wandlern aufgetragen wird.

5. Verfahren nach vorhergehendem Anspruch, **dadurch gekennzeichnet, dass** eine Schicht aus dielektrischem Material auf die reflektierende Schicht des Trägersubstrats aufgetragen wird, um einen dielektrisch-dielektrischen Kontakt zu gewährleisten, wenn die eingeebnete Seite des Griffsubstrats auf die Oberseite des Trägersubstrats übertragen wird.

6. Verfahren nach einem der vorhergehenden Ansprüche, **dadurch gekennzeichnet, dass** es einen Schritt zur Herstellung von Ausrichtungsmarkierungen umfasst, wobei die Ausrichtungsmarkierungen im Griffsubstrat oder in der Harzschicht hergestellt werden, wobei Ausrichtungsmarkierungen auch im Trägersubstrat vorhanden sind, um die Gegenüberstellung jedes der Harzmuster mit einem photoelektrischen Wandler zu gewährleisten.

7. Verfahren nach einem der vorhergehenden Ansprüche, **dadurch gekennzeichnet, dass** es einen Schritt des Aufbringens einer Stoppschicht vor dem Schritt des Aufbringens der Harzschicht umfasst, wobei das Entfernen des Griffsubstrats an der Stoppschicht endet und vom Entfernen der Stoppschicht gefolgt wird, so dass die strukturierte Harzschicht an der Oberfläche freigesetzt wird.

8. Verfahren nach einem der vorhergehenden Ansprüche, **dadurch gekennzeichnet, dass** es einen Schritt zur Herstellung von Luftwänden umfasst, die die dielektrischen Muster der Fabry-Pérot-Hohlräumen trennen.

9. Verfahren nach einem der Ansprüche 1 bis 7, **dadurch gekennzeichnet, dass** es einen Schritt zur Herstellung von Wänden aus einem Material umfasst, das einen optischen Brechungsindex aufweist, der strikt unter dem Brechungsindex des dielektrischen Materials liegt, das dazu bestimmt ist, die dielektrischen Muster der Fabry-Pérot-Hohlräume zu bilden, wobei die Wände die dielektrischen Muster der Fabry-Pérot-Hohlräume voneinander trennen.

10. Verfahren nach einem der vorhergehenden Ansprüche, **dadurch gekennzeichnet, dass** es zusätzlich zur Herstellung von mindestens zwei Farbfiltern, wobei jeder Filter eine erste reflektierende Schicht, eine zweite reflektierende Schicht, eine Schicht aus dielektrischem Material eines Fabry-Pérot-Hohlraums zwischen der ersten reflektierenden Schicht und der zweiten reflektierenden Schicht umfasst, auch die Herstellung mindestens eines weiteren Farbfilters mit einer ersten reflektierenden Schicht, einer zweiten reflektierenden Schicht, einer Schicht aus dielektrischem Material eines Fabry-Pérot-Hohlraums, eines sogenannten zweiten Typs, zwischen der ersten reflektierenden Schicht und der zweiten reflektierenden Schicht umfasst, wobei sich das dielektrische Material dieses weiteren Farbfilters von dem dielektrischen Material der beiden Farbfilter unterscheidet.

11. Verfahren nach dem vorhergehenden Anspruch, **dadurch gekennzeichnet, dass** der Schritt der dreidimensionalen Strukturierung der Harzschicht durch Lithografie so durchgeführt wird, dass ein freier Platz entsteht, in dem das dielektrische Material zur Bildung des Musters des Fabry-Pérot-Hohlraums eines zweiten Typs aufgetragen wird.

## Claims

1. A method (100) for manufacturing a multispectral filter for electromagnetic radiation, said filter including at least two colour filters (Fi), each filter including a first reflective layer (215), a second reflective layer (218), and a layer of dielectric material (207) of Fabry-Perot cavity between the first reflective layer (215) and the second reflective layer (218), the thickness of the dielectric layer of both colour filters being different and each of both filters (Fi) facing a photoelectric transducer (214Ai), said method including the following steps of:

   - Depositing (102) a resin layer (204) on a substrate (200), called the handle substrate;
   - Three-dimensionally structuring (102) the resin layer (204) by lithography so as to obtain at least two resin patterns (204Ai) of different heights, at least one of the patterns having a maximum reference height (Hmax), the height being measured perpendicularly to the plane of the substrate (200);
   - Depositing (104) a layer (206) made of the dielectric material intended to form the dielectric patterns of the Fabry-Perot cavities, said layer of dielectric material (206) covering the entire resin patterns (204Ai) by having an upper surface (219), each point of which is located at a height relative to the handle substrate (200) greater than the maximum reference height (Hmax);

- Planarising (105) by removal of the dielectric material with a selective stop at the top of the highest resin pattern;

- Transferring (106, 107) the planarised face (208) of the handle substrate to the upper face (212) of a substrate (210), called the carrier substrate, including at least two photoelectric transducers (214Ai), each of said patterns facing a photoelectric transducer, a reflective layer (215) intended to form the first reflective layer of both colour filters being positioned at the transfer interface between the handle substrate and the carrier substrate;

- Removing (108) the handle substrate (200);

- Removing (110) the resin (204) so as to release at least two dielectric patterns (217Ai) of Fabry-Perot cavities of different thicknesses on the surface;

- Depositing (111) a reflective layer (218) onto the at least two dielectric patterns of Fabry-Perot cavity, forming the second reflective layer of both colour filters.

2. The method according to claim 1, **characterised in that** the structuring step is followed, prior to depositing the layer made of the dielectric material intended to form the dielectric patterns of the Fabry-Perot cavities, by a step of conformally depositing an encapsulation layer onto the resin patterns.

3. The method according to one of the preceding claims, **characterised in that** the lithography used for the structuring step is a so-called Grayscale lithography.

4. The method according to one of the preceding claims, **characterised in that** the reflective layer intended to form the first reflective layer of the colour filters is previously deposited onto the carrier substrate above the photoelectric transducers.

5. The method according to the preceding claim, **characterised in that** a layer of dielectric material is deposited onto said reflective layer of the carrier substrate so as to ensure a dielectric/dielectric contact when transferring the planarised face of the handle substrate to the upper face of the carrier substrate.

6. The method according to one of the preceding claims, **characterised in that** it includes a step of making alignment marks, said alignment marks being made in the handle substrate or in the resin layer, alignment marks also being present in the carrier substrate so as to ensure that each of the resin patterns faces a photoelectric transducer.

7. The method according to one of the preceding claims, **characterised in that** it includes a step of depositing a barrier layer prior to the step of depositing the resin layer, the removal of the handle substrate stopping on said barrier layer and being followed by the removal of the barrier layer so as to release the structured resin layer on the surface.

8. The method according to one of the preceding claims, **characterised in that** it includes a step of making air walls separating the dielectric patterns of Fabry-Perot cavities.

9. The method according to one of claims 1 to 7, **characterised in that** it includes a step of making walls of material having an optical refractive index strictly lower than the refractive index of the dielectric material intended to form the dielectric patterns of the Fabry-Perot cavities, said walls separating the dielectric patterns of the Fabry-Perot cavities.

10. The method according to one of the preceding claims, **characterised in that** it includes, in addition to making at least two colour filters, each filter including a first reflective layer, a second reflective layer, a layer of dielectric material of Fabry-Perot cavity between the first reflective layer and the second reflective layer, making at least one other colour filter including a first reflective layer, a second reflective layer, a layer of dielectric material of Fabry-Perot cavity, called of a second type, between the first reflective layer and the second reflective layer, the dielectric material of this other colour filter being different from the dielectric material of both colour filters.

11. The method according to the preceding claim, **characterised in that** said step of three-dimensionally structuring the resin layer by lithography is carried out so as to obtain a free location in which the dielectric material intended to form the pattern of the Fabry-Perot cavity of a second type is deposited.

Fig. 1

101

**Fig. 2**

102

**Fig. 3**

103

**Fig. 5**

**Fig. 4**

**Fig. 6**

**Fig. 7**

**Fig. 8**

**Fig. 9**

**Fig. 10**

**Fig. 11**

**Fig. 12**

**Fig. 13**

Fig. 14

301

**Fig. 15**

302

**Fig. 16**

303

419

405

404

401

403

400

## Fig. 17

304

404A1  427

406

404A1

404

$h_{max}$

419

401

403

400

## Fig. 18

305

404A1    404A5    408

405

406

**Fig. 19**

306

404A2  404A3        404A5 404A6  404A7  409

401  403

404A1  419  406

408

412  416
415

413  411

410  414A1 414A2 414A3 414A4 414A5 414A6 414A7

# Fig. 20

307

**Fig. 21**

400
401
408
416

308

**Fig. 22**

401

309

404A1 404A2 404A3 404A5 404A6 404A7

404

405

419

405 408
416 412

413 411

414A1 414A2 414A3 414A4 414A5 414A6 414A7

**Fig. 23**

310

404A2 404A3 404A5 404A6 404A7

421

420

404

404A1

405 419

416

411

**Fig. 24**

311

**Fig. 25**

312

422
423

421

420

419

405

**Fig. 26**

313

404

420

405
412
415
425
413

415

411

**Fig. 27**

314

426

424

420

$h_{HM}$

404

$h_{max}$

425

407

405

416

415

413

411

## Fig. 28

315

420

404

426

407

405

416

415

413

411

## Fig. 29

316

**Fig. 30**

317

**Fig. 31**

**Fig. 32**

**Fig. 33**

EP 4 220 723 B1

500

| 501 | 502 | 503 | 504 | 505 | 506 | 507 | 508 | 509 | 510 | 511 | 512 | 513 | 514 |

**Fig. 34**

Fig. 35

Fig. 36

Vue de dessus

Vue en coupe

508

602

204

201

203

200

603   603   603

602                                                    601

208

207

204A1   204A2   204A3   204A4

## Fig. 37

509

205

201

203

200

603   603   603

207

204A1   204A2   204A3   204A4

## Fig. 38

**Fig. 39**

700

701 — 702 — 703 — 704 — 705 — 706 — 707 — 708 — 709 — 710 — 711 — 712 — 713 — 714 — 715 — 716 — 717

Fig. 40

710

800

204

205

201

203

200

204A1  204A2  204A3  204A4

207

603

**Fig. 41**

711

800  603  207

204

205

201

203

200

204A1  204A2  204A3  204A4

Vue en coupe

207  800

205

Vue de dessus

**Fig. 42**

EP 4 220 723 B1

717

F6    218    F5    F4    F3    F2    F1

205    218

207    800

216    800

215

211    210

**Fig. 43**

Fig. 44

904

205

718

201

203

200

**Fig. 45**

905

205

718

201

203

200

**Fig. 46**

906

719

205

718

201

203

200

**Fig. 47**

907

720

205

718

201

203

200

Vue en coupe

720

718

720

205

Vue de dessus

**Fig. 48**

EP 4 220 723 B1

908

721

205

201

203

200

Vue en coupe

721

205

Vue de dessus

**Fig. 49**

EP 4 220 723 B1

**EP 4 220 723 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6031653 A
- EP 2522968 A
- WO 2019239139 A